# EUROPÄISCHE PATENTSCHRIFT

(11) **EP 3 864 941 B1**
(45) Veröffentlichungstag und Bekanntmachung des Hinweises auf die Patenterteilung: **11.06.2025**
(21) Anmeldenummer: 19786314.5
(22) Anmeldetag: 08.10.2019
(51) Int. Cl.: H05K 5/06

(54) **GEHÄUSEDECKEL**
HOUSING COVER
COUVERCLE DE BOÎTIER

(30) Priorität: 12.10.2018 DE 102018125294
(43) Veröffentlichungstag der Anmeldung: 18.08.2021
(73) Patentinhaber: ElringKlinger AG, 72581 Dettingen (DE)
(72) Erfinder: GÖHL, Kristian, 72760 Reutlingen (DE); HÖVEMEYER, Johannes, 72581 Dettingen (DE); EBERLE, Bernhard, 72555 Metzingen (DE); SCHÖLLHAMMER, Jochen, 72581 Dettingen (DE); GOLCHERT, Bodo, 72649 Wolfschlugen (DE); WOLFER, Andreas, 73252 Lenningen (DE)
(74) Vertreter: Hoeger, Stellrecht & Partner Patentanwälte mbB
(86) Internationale Anmeldenummer: PCT/EP2019/077169
(87) Internationale Veröffentlichungsnummer: WO 2020/074482

(56) Entgegenhaltungen:
- EP-A1- 3 163 986
- DE-A1- 102012 023 857
- DE-A1- 19 704 532
- JP-A- 2015 141 991
- US-A1- 2015 146 347

## Beschreibung

Die vorliegende Erfindung betrifft einen Gehäusedeckel zum Festlegen an einem Gehäuse, insbesondere an einem Wechselrichter-Gehäuse, wobei der Gehäusedeckel mit mehreren Befestigungsmittel-Durchtrittsöffnungen und mit einem Dichtungswulst, der ein elastomeres Material umfasst, versehen ist und wobei der Dichtungswulst an einer Dichtungstragefläche des Gehäusedeckels angeordnet ist.

Aus der EP 1 683 997 A2 ist ein Gehäusedeckel bekannt, bei welchem ein Dichtungswulst aus einem Elastomermaterial in einer in den Gehäusedeckel eingeprägten Nut angeordnet ist.

Durch das Erfordernis, in dem Gehäusedeckel eine Nut vorzusehen, deren Breite im unverpressten Zustand des Gehäusedeckels größer sein muss als die Breite des Dichtungswulstes, wird die Gestaltungsfreiheit beim Design des Gehäusedeckels eingeschränkt.

Die DE 10 2012 023857 A1 und die US 2015/146347 A1 offenbaren Gehäusedeckel zum Festlegen an einem Gehäuse, wobei der jeweilige Gehäusedeckel mit mehreren Befestigungsmittel-Durchtrittsöffnungen und mit einem Dichtungswulst, der ein elastomeres Material umfasst, versehen ist, wobei der Dichtungswulst an einer Dichtungstragefläche des Gehäusedeckels angeordnet ist und
wobei der Gehäusedeckel mindestens ein Verformungsbegrenzungselement umfasst, welches über die Dichtungstragefläche in derselben Richtung vorsteht wie der Dichtungswulst und eine Verformung des Dichtungswulstes im montierten Zustand des Gehäusedeckels begrenzt.

Die JP 2015 141991 A offenbart einen Gehäusedeckel gemäß dem Oberbegriff von Anspruch 1.

Der vorliegenden Erfindung liegt die Aufgabe zugrunde, einen Gehäusedeckel der eingangs genannten Art zu schaffen, bei welchem der Verlauf der Dichtungswulst freier gestaltbar und insbesondere näher an die Befestigungsmittel-Durchtrittsöffnungen des Gehäusedeckels heran legbar ist.

Diese Aufgabe wird durch einen Gehäusedeckel nach Anspruch 1 gelöst.

Bei dem erfindungsgemäßen Gehäusedeckel liegt im montierten Zustand des Gehäusedeckels, in welchem der Dichtungswulst zwischen dem Gehäusedeckel und dem mittels des Gehäusedeckels zu verschließenden Gehäuse verpresst wird, das Verformungsbegrenzungselement im Kraft-Hauptschluss und der Dichtungswulst im Kraft-Nebenschluss. Hierdurch wird eine übermäßige Verformung des Dichtungswulstes vermieden.

Das mindestens eine Verformungsbegrenzungselement kann durch Umformung eines, vorzugsweise metallischen, Grundkörpers des Gehäusedeckels, beispielsweise durch einen Prägevorgang oder einen Tiefziehvorgang, erzeugt sein.

Das Verformungsbegrenzungselement kann topographisch ausgeführt sein, das heißt die Höhe H des Verformungsbegrenzungselements (wobei die Höhe eines Elements dessen Erstreckung in der Normalenrichtung der Dichtungstragefläche bezeichnet) kann in einer Längsrichtung des Verformungsbegrenzungselements variieren. Insbesondere kann vorgesehen sein, dass die Höhe H des Verformungsbegrenzungselements in Abhängigkeit vom jeweiligen Abstand von der nächstgelegenen Befestigungsmittel-Durchtrittsöffnung variiert.

Vorzugsweise ist dabei vorgesehen, dass die Höhe H des Verformungsbegrenzungselements mit wachsendem Abstand von der nächstgelegenen Befestigungsmittel-Durchtrittsöffnung zunimmt. Durch die so gestaltete Topographie des Verformungsbegrenzungselements wird die Variation der Flächenpressung, mit welcher der Gehäusedeckel mittels der durch die Befestigungsmittel-Durchtrittsöffnungen hindurchtretenden Befestigungsmittel, insbesondere Befestigungsschrauben, verspannt wird, in der Längsrichtung des Dichtungswulstes, welche aufgrund der variierenden Abstände von dem jeweils nächstliegenden Befestigungsmittel hervorgerufen wird, zumindest teilweise ausgeglichen und somit ein gleichmäßiges Anliegen des Dichtungswulstes an dem zu verschließenden Gehäuse an jeder Stelle des Dichtungswulstes erzielt.

Die Topographie des Verformungsbegrenzungselements wird vorzugsweise bei dem Umformvorgang erzeugt, durch welchen das Verformungsbegrenzungselement an dem Grundkörper des Gehäusedeckels gebildet wird.

Bei einer bevorzugten Ausgestaltung der Erfindung ist vorgesehen, dass mindestens ein Abschnitt mindestens eines Verformungsbegrenzungselements sich längs der Umfangsrichtung einer Befestigungsmittel-Durchtrittsöffnung um einen Umfangswinkel von mindestens 240° um die Befestigungsmittel-Durchtrittsöffnung herum erstreckt.

Ferner kann vorgesehen sein, dass sich der Abschnitt mindestens eines Verformungsbegrenzungselements längs der Umfangsrichtung der Befestigungsmittel-Durchtrittsöffnung um einen Umfangswinkel von weniger als 360°, insbesondere von weniger als 300°, besonders bevorzugt von weniger als 240°, um die betreffende Befestigungsmittel-Durchtrittsöffnung herum erstreckt.

Alternativ oder ergänzend hierzu kann vorgesehen sein, dass mindestens ein Abschnitt mindestens eines Verformungsbegrenzungselements sich ringförmig geschlossen um eine Befestigungsmittel-Durchtrittsöffnung herum erstreckt.

Bei einer bevorzugten Ausgestaltung der Erfindung ist vorgesehen, dass mindestens ein Abschnitt mindestens eines Verformungsbegrenzungselements auf einer dem Dichtungswulst abgewandten Seite einer Befestigungsmittel-Durchtrittsöffnung angeordnet ist.

Insbesondere kann vorgesehen sein, dass der mindestens eine Abschnitt des mindestens einen Verformungsbegrenzungselements zwischen der Befestigungsmittel-Durchtrittsöffnung und einem äußeren Rand des Gehäusedeckels angeordnet ist.

An dem Gehäusedeckel können mehrere Verformungsbegrenzungselemente vorgesehen sein, welche sich längs einer Umfangsrichtung des Gehäusedeckels erstrecken und längs der Umfangsrichtung des Gehäusedeckels voneinander beabstandet sind.

Dem Dichtungswulst ist bei einer solchen Ausführungsform also nur partiell ein Verformungsbegrenzungselement zugeordnet; mindestens ein Abschnitt des Dichtungswulstes verläuft in diesem Fall nicht benachbart und/oder parallel zu einem Verformungsbegrenzungselement des Gehäusedeckels.

Der Dichtungswulst ist vorzugsweise ringförmig geschlossen ausgebildet.

Ein von dem Dichtungswulst umgebener Bereich der Dichtungstragefläche ist vorzugsweise im Wesentlichen eben ausgebildet.

Insbesondere kann vorgesehen sein, dass der gesamte von dem Dichtungswulst umgebene Bereich der Dichtungstragefläche im Wesentlichen eben ausgebildet ist.

Das Verformungsbegrenzungselement kann einen sich in einer Längsrichtung des Verformungsbegrenzungselements erstreckenden Vorsprung umfassen. Ein solcher Vorsprung kann als eine Sicke, insbesondere als eine Vollsicke, ausgebildet sein.

Ferner ist vorgesehen, dass dem Verformungsbegrenzungselement eine Vertiefung an der der Dichtungstragefläche abgewandten Außenseite eines - vorzugsweise metallischen - Grundkörpers des Gehäusedeckels zugeordnet ist.

Dabei kann mindestens eine Befestigungsmittel-Durchtrittsöffnung des Gehäusedeckels in eine Vertiefung, die einem Verformungsbegrenzungselement zugeordnet ist, münden. In diesem Fall reicht die Vertiefung bis unmittelbar an den Rand der Befestigungsmittel-Durchtrittsöffnung heran.

Ferner kann vorgesehen sein, dass auch das Verformungsbegrenzungselement bis unmittelbar an den Rand der Befestigungsmittel-Durchtrittsöffnung heranreicht.

Ein eine Befestigungsmittel-Durchtrittsöffnung im montierten Zustand des Gehäusedeckels durchsetzendes Befestigungsmittel, beispielsweise eine Befestigungsschraube, kann an einer die Befestigungsmittel-Durchtrittsöffnung umgebenden Vertiefung, insbesondere an einem Boden der Vertiefung, anliegen, beispielsweise mit einem Kopf des Befestigungsmittels, beispielsweise der Befestigungsschraube, vorzugsweise mit im Wesentlichen der gesamten schaftseitigen Anlagefläche des Kopfes.

Das Verformungsbegrenzungselement kann im montierten Zustand des Gehäusedeckels ganz oder teilweise zwischen dem Befestigungsmittel, insbesondere einem Kopf des Befestigungsmittels, beispielsweise einer Befestigungsschraube, und dem mittels des Gehäusedeckels zu verschließenden Gehäuse angeordnet sein. In diesem Fall wird das Verformungsbegrenzungselement durch das Befestigungsmittel selbst unmittelbar auf Block verpresst.

Der Dichtungswulst kann im montierten Zustand des Gehäusedeckels ganz oder teilweise im Bereich zwischen einem Kopf des Befestigungsmittels, beispielsweise einer Befestigungsschraube, und dem mittels des Gehäusedeckels zu verschließenden Gehäuse angeordnet sein. Hierdurch wird eine besonders hohe auf den Dichtungswulst einwirkende Anpresskraft und somit eine hohe Abdichtkraft erzielt.

Der Dichtungswulst kann so angeordnet sein, dass er - in einer senkrecht zur Dichtungstragefläche ausgerichteten Z-Richtung gesehen - über seine gesamte Breite b oder über einen Teil seiner Breite b hinweg von einem Abschnitt der die Befestigungsmittel-Durchtrittsöffnung umgebenden Vertiefung überlappt wird.

Das Verformungsbegrenzungselement kann in einem Bereich, welcher zwischen einer Befestigungsmittel-Durchtrittsöffnung einerseits und dem Dichtungswulst andererseits liegt, eine verringerte Breite B" aufweisen, was es ermöglicht, den Dichtungswulst dort möglichst nah an die betreffende Befestigungsmittel-Durchtrittsöffnung heranzuführen.

Das Verformungsbegrenzungselement kann in einem solchen Bereich einen im Wesentlichen geradlinigen, vorzugsweise im Wesentlichen parallel zum Dichtungswulst verlaufenden, Rand aufweisen.

Die dem Verformungsbegrenzungselement zugeordnete und sich um dieselbe Befestigungsmittel-Durchtrittsöffnung herum erstreckende Vertiefung kann einen (vorzugsweise kreisabschnittsförmigen) Bereich, welcher - in der Z-Richtung gesehen - nicht mit dem Verformungsbegrenzungselement überlappt, umfassen.

Um zu vermeiden, dass die verringerte Breite B" des Verformungsbegrenzungselements in dem vorstehend genannten Bereich zu einer unzulässig hohen Flächenpressung im montierten Zustand des Gehäusedeckels führt, kann vorgesehen sein, dass ein anderer Bereich des Verformungsbegrenzungselements, welcher sich um dieselbe Befestigungsmittel-Durchtrittsöffnung herum erstreckt, eine größere Breite aufweist, und/oder dass das Verformungsbegrenzungselement einen Bereich umfasst, welcher sich in einer im Wesentlichen parallel zum Dichtungswulst verlaufenden Richtung an den Bereich des Verformungsbegrenzungselements, welcher eine verringerte Breite aufweist, anschließt.

Ein Abschnitt eines Verformungsbegrenzungselements, welches sich längs einer Umfangsrichtung einer Befestigungsmittel-Durchtrittsöffnung ganz oder teilweise um die betreffende Befestigungsmittel-Durchtrittsöffnung herum erstreckt, kann eine maximale Breite B und eine minimale Breite B" aufweisen. Die Breite B beziehungsweise B" entspricht dabei dem Abstand zwischen einem der Befestigungsmittel-Durchtrittsöffnung zugewandten inneren Rand und einem der Befestigungsmittel-Durchtrittsöffnung abgewandten äußeren Rand des Abschnitts des Verformungsbegrenzungselements.

Der innere Rand des Abschnitts des Verformungsbegrenzungselements kann dabei mit dem Rand der Befestigungsmittel-Durchtrittsöffnung zusammenfallen.

Die maximale Breite B des Abschnitts des Verformungsbegrenzungselements beträgt vorzugsweise höchstens 100 % des Durchmessers der Befestigungsmittel-Durchtrittsöffnung, insbesondere höchstens 60 % des Durchmessers der Befestigungsmittel-Durchtrittsöffnung, besonders bevorzugt höchstens 20 % des Durchmessers der Befestigungsmittel-Durchtrittsöffnung.

Die minimale Breite B" des Abschnitts des Verformungsbegrenzungselements beträgt vorzugsweise weniger als 50 % der maximalen Breite B des Abschnitts des Verformungsbegrenzungselements.

Ein den inneren Rand und den äußeren Rand des Abschnitts des Verformungsbegrenzungselements miteinander verbindender Randabschnitt kann im Wesentlichen tangential zu der Befestigungsmittel-Durchtrittsöffnung angeordnet sein. In diesem Fall ist die minimale Breite B" des Abschnitts des Verformungsbegrenzungselements gleich null.

Der innere Rand des Abschnitts des Verformungsbegrenzungselements kann sich über einen Umfangswinkel α (bezogen auf die Mittelachse der Befestigungsmittel-Durchtrittsöffnung) von 360° oder weniger, vorzugsweise von 320° oder weniger, insbesondere von 270° oder weniger, besonders bevorzugt von 180° oder weniger, erstrecken.

Der äußere Rand des Abschnitts des Verformungsbegrenzungselements kann sich über einen Umfangswinkel β (bezogen auf die Mittelachse der Befestigungsmittel-Durchtrittsöffnung) von 360° oder weniger, vorzugsweise von 320° oder weniger, insbesondere von 270° oder weniger, besonders bevorzugt von 180° oder weniger, erstrecken.

Der Umfangswinkel α, längs welchem sich der innere Rand des Abschnitts des Verformungsbegrenzungselements um die Befestigungsmittel-Durchtrittsöffnung herum erstreckt, kann im Wesentlichen gleich groß sein wie der Umfangswinkel β, längs welchem sich der äußere Rand des Abschnitts des Verformungsbegrenzungselements um die Befestigungsmittel-Durchtrittsöffnung herum erstreckt. In diesem Fall können die Randabschnitte, welche den inneren Rand und den äußeren Rand des Abschnitts des Verformungsbegrenzungselements miteinander verbinden, im Wesentlichen radial zur Mittelachse der Befestigungsmittel-Durchtrittsöffnung ausgerichtet sein.

Bei besonderen Ausgestaltungen des Verformungsbegrenzungselements ist hingegen vorgesehen, dass der Umfangswinkel α größer ist als der Umfangswinkel β. In diesem Fall sind die Randabschnitte des Verformungsbegrenzungselements, welche den inneren Rand mit dem äußeren Rand des Verformungsbegrenzungselements verbinden, nicht-radial in Bezug auf die Mittelachse der Befestigungsmittel-Durchtrittsöffnung ausgerichtet.

Insbesondere kann vorgesehen sein, dass die Randabschnitte des Abschnitts des Verformungsbegrenzungselements, welche den inneren Rand und den äußeren Rand des Abschnitts des Verformungsbegrenzungselements miteinander verbinden, im Wesentlichen parallel zu dem Dichtungswulst ausgerichtet sind.

Der Abstand d des Dichtungswulstes von den Randabschnitten des Abschnitts des Verformungsbegrenzungselements beträgt vorzugsweise mindestens 0,5 mm, insbesondere mindestens 0,7 mm, besonders bevorzugt mindestens 1,0 mm.

Wenn der Abschnitt des Verformungsbegrenzungselements sich nicht vollständig um die Befestigungsmittel-Durchtrittsöffnung herum erstreckt, so ist vorzugsweise der Abstand d' des Dichtungswulstes von dem Rand der Befestigungsmittel-Durchtrittsöffnung abschnittsweise kleiner als der Abstand d des Dichtungswulstes von dem Verformungsbegrenzungselement.

In diesem Fall beträgt der Abstand d' des Dichtungswulstes von dem Rand der Befestigungsmittel-Durchtrittsöffnung vorzugsweise mindestens 0,5 mm, insbesondere mindestens 0,7 mm, besonders bevorzugt mindestens 1,0 mm.

Bei einer bevorzugten Ausgestaltung der Erfindung ist vorgesehen, dass der Dichtungswulst zumindest abschnittsweise in einem Abstand d von dem Verformungsbegrenzungselement verläuft, welcher kleiner ist als die Breite b des Dichtungswulstes und/oder kleiner ist als die Breite B des Verformungsbegrenzungselements.

Die Breite des Verformungsbegrenzungselements ist vorzugsweise kleiner als das Vierfache, insbesondere kleiner als das Dreifache, besonders bevorzugt kleiner als das Doppelte, der Breite b des Dichtungswulstes.

Vorzugsweise umfasst die Dichtungstragefläche einen im Wesentlichen ebenen Bereich, welcher den Dichtungswulst trägt und auf der dem Verformungsbegrenzungselement abgewandten Seite des Dichtungswulstes eine Breite aufweist, welche größer ist als die Breite b des Dichtungswulstes.

Ein Grundkörper des Gehäusedeckels, an welchem der Dichtungswulst angeordnet ist, ist vorzugsweise als ein Blechformteil ausgebildet.

Ein metallischer Grundkörper des Gehäusedeckels, an welchem der Dichtungswulst angeordnet ist, umfasst vorzugsweise Aluminium oder eine Aluminium-Legierung.

Zur Versteifung des Gehäusedeckels im Bereich des äußeren Randes des Gehäusedeckels kann vorgesehen sein, dass ein auf der dem Dichtungswulst abgewandten Seite des Verformungsbegrenzungselements verlaufender Randbereich des Gehäusedeckels eine Biegung aufweist.

Dabei kann vorgesehen sein, dass der Randbereich des Gehäusedeckels von der das Dichtelement tragenden Seite eines Grundkörpers des Gehäusedeckels weg gebogen ist oder zu der das Dichtelement tragenden Seite des Grundkörpers des Gehäusedeckels hin gebogen ist.

Ein solcher mit einer Biegung versehener Randbereich des Gehäusedeckels kann - von der das Dichtelement tragenden Seite des Grundkörpers her gesehen - konvex oder konkav gekrümmt sein.

Weitere Merkmale und Vorteile der Erfindung sind Gegenstand der nachfolgenden Beschreibung und der zeichnerischen Darstellung eines Ausführungsbeispiels.

In den Zeichnungen zeigen:
- Fig. 1: eine perspektivische Darstellung eines Gehäusedeckels, mit der Blickrichtung auf eine mit einem Dichtungswulst und Verformungsbegrenzungselementen versehene Innenseite des Gehäusedeckels;
- Fig. 2: eine perspektivische Darstellung des Gehäusedeckels aus Fig. 1, mit der Blickrichtung auf eine mit Vertiefungen versehene Außenseite des Gehäusedeckels;
- Fig. 3: eine Draufsicht von oben auf die mit dem Dichtungswulst und den Verformungsbegrenzungselementen versehene Innenseite des Gehäusedeckels;
- Fig. 4: eine Draufsicht auf die mit den Vertiefungen versehene Außenseite des Gehäusedeckels;
- Fig. 5: einen Querschnitt durch den Gehäusedeckel aus den Fig. 1 bis 4 durch einen Bereich eines Gehäuses, an welchem der Gehäusedeckel angeordnet ist, und durch Befestigungsmittel zum lösbaren Festlegen des Gehäusedeckels an dem Gehäuse, in einem unverpressten Zustand des Dichtungswulstes;
- Fig. 6: eine vergrößerte Darstellung des Bereichs I aus Fig. 5, ohne das Befestigungsmittel, in einem unverpressten Zustand des Dichtungswulstes;
- Fig. 7: eine Darstellung des Bereichs I aus Fig. 5 in einem verpressten Zustand des Dichtungswulstes;
- Fig. 8: eine vergrößerte Darstellung des Bereichs II aus Fig. 4;
- Fig. 9: einen ausschnittsweisen Querschnitt durch den Gehäusedeckel und einen Bereich des Gehäuses längs der Linie 9 - 9 in Fig. 4, in einem unverpressten Zustand des Dichtungswulstes;
- Fig. 10: einen ausschnittsweisen Querschnitt durch den Gehäusedeckel, einen Bereich des Gehäuses und ein Befestigungsmittel, mittels welchem der Gehäusedeckel an dem Gehäuse lösbar festgelegt ist, längs der Linie 9 - 9 in Fig. 4, in einem verpressten Zustand des Dichtungswulstes;
- Fig. 11: einen ausschnittsweisen Querschnitt durch den Gehäusedeckel längs der Linie 11 - 11 in Fig. 4, in einem unverpressten Zustand des Dichtungswulstes;
- Fig. 12: einen ausschnittsweisen Querschnitt durch den Gehäusedeckel und einen Bereich des Gehäuses längs der Linie 12 - 12 in Fig. 4, in einem unverpressten Zustand des Dichtungswulstes;
- Fig. 13: einen ausschnittsweisen Querschnitt durch den Gehäusedeckel, einen Bereich des Gehäuses und ein Befestigungsmittel, mittels welchem der Gehäusedeckel lösbar an dem Gehäuse festgelegt ist, längs der Linie 12 - 12 in Fig. 4, in einem verpressten Zustand des Dichtungswulstes;
- Fig. 14: einen ausschnittsweisen Querschnitt durch den Gehäusedeckel und einen Bereich des Gehäuses längs der Linie 14 - 14 in Fig. 4, in einem unverpressten Zustand des Dichtungswulstes;
- Fig. 15: einen ausschnittsweisen Querschnitt durch den Gehäusedeckel, einen Bereich des Gehäuses und ein Befestigungsmittel, mittels welchem der Gehäusedeckel lösbar an dem Gehäuse festgelegt ist, längs der Linie 14 - 14 in Fig. 4, in einem verpressten Zustand des Dichtungswulstes;
- Fig. 16: eine Draufsicht auf die Dichtungstragefläche des Gehäusedeckels, welche einen Abschnitt eines Verformungsbegrenzungselements zeigt, der sich um eine Befestigungsmittel-Durchtrittsöffnung herum erstreckt und auf der dem Dichtungswulst zugewandten Seite der Befestigungsmittel-Durchtrittsöffnung eine kleinere Breite B'' aufweist als auf der dem Dichtungswulst abgewandten Seite der Befestigungsmittel-Durchtrittsöffnung;
- Fig. 17: eine Draufsicht auf eine alternative Ausführungsform des Abschnitts des Verformungsbegrenzungselements aus Fig. 16, bei welcher einen inneren Rand und einen äußeren Rand des Abschnitts des Verformungsbegrenzungselements miteinander verbindende Randabschnitte des Verformungsbegrenzungselements im Wesentlichen tangential zu dem Rand der Befestigungsmittel-Durchtrittsöffnung verlaufen;

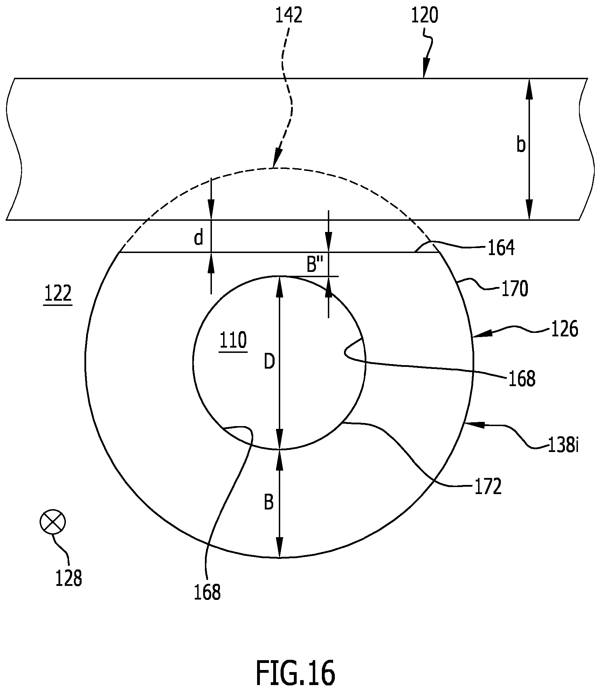

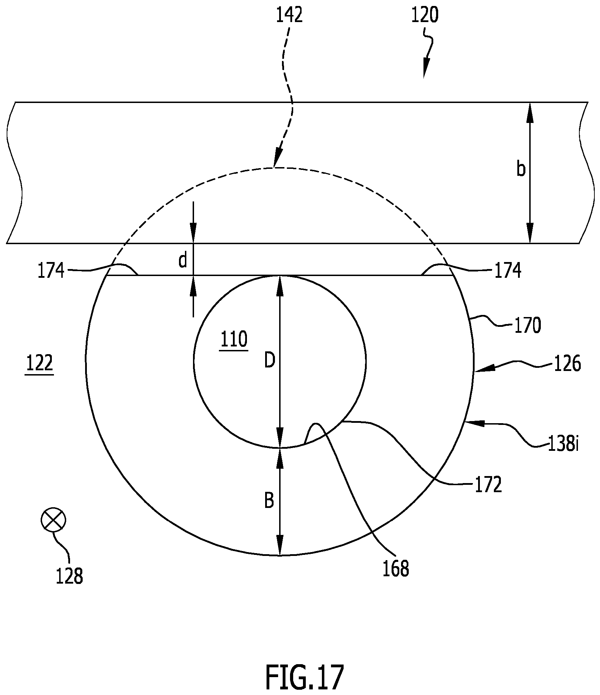

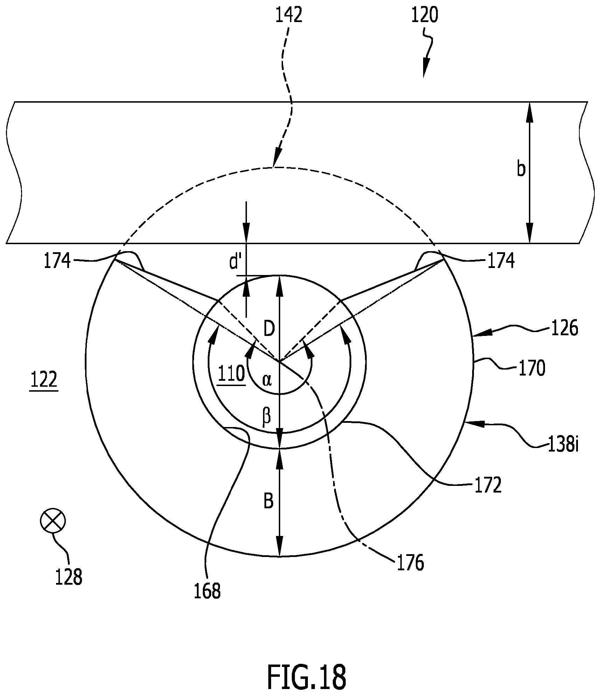

- Fig. 18: eine Draufsicht auf eine alternative Ausführungsform des Abschnitts des Verformungsbegrenzungselements aus den Fig. 16 und 17, bei welcher der innere Rand des Abschnitts des Verformungsbegrenzungselements sich längs eines Umfangswinkels α um die Mittelachse der Befestigungsmittel-Durchtrittsöffnung herum erstreckt und der äußere Rand des Abschnitts des Verformungsbegrenzungselements sich längs eines Umfangswinkels β um die Mittelachse der Befestigungsmittel-Durchtrittsöffnung herum erstreckt, wobei der Umfangwinkel α größer ist als der Umfangswinkel β und beide Umfangswinkel α und β kleiner sind als 360°; und
- Fig. 19: eine Draufsicht auf eine alternative Ausführungsform des Abschnitts des Verformungsbegrenzungselements aus Fig. 18, bei welcher die Randabschnitte, welche den inneren Rand und den äußeren Rand des Abschnitts des Verformungsbegrenzungselements miteinander verbinden, im Wesentlichen parallel zu einem Rand des Dichtungswulstes verlaufen.

Gleiche oder funktional äquivalente Elemente sind allen Figuren mit denselben Bezugszeichen bezeichnet.

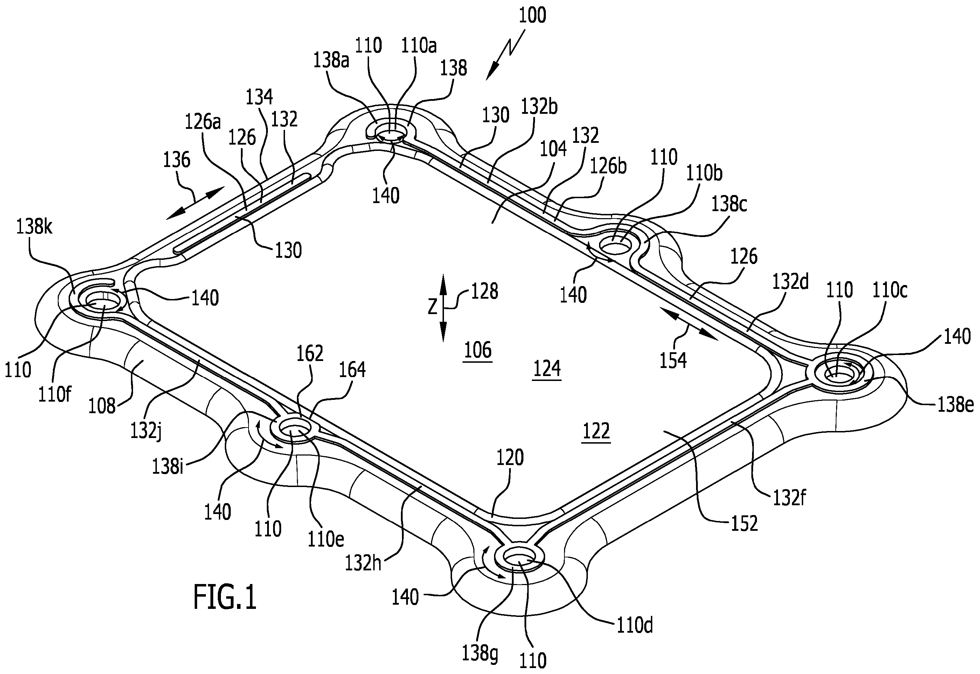

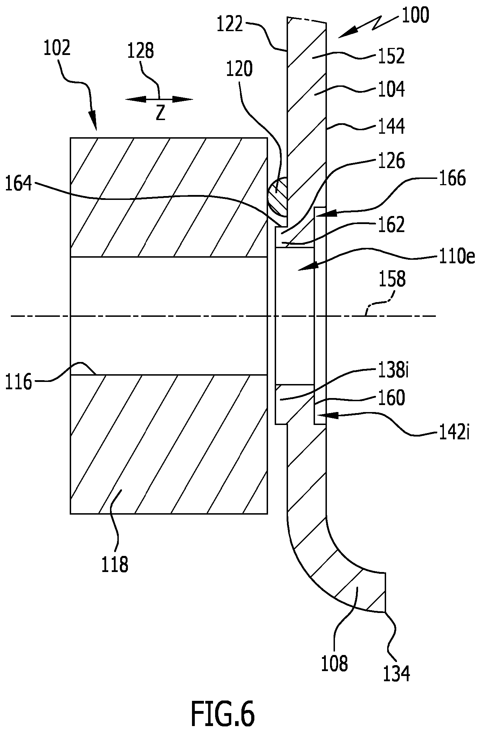

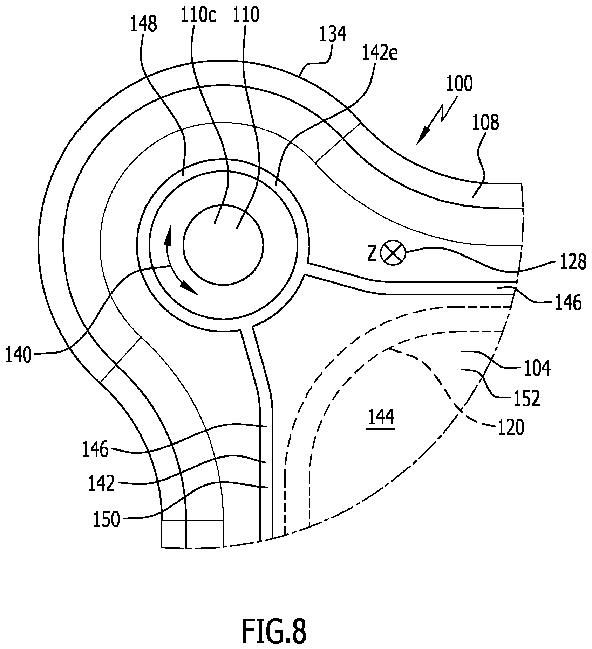

Ein in den Fig. 1 bis 15 dargestellter, als Ganzes mit 100 bezeichneter Gehäusedeckel ist zum Verschließen einer Gehäuseöffnung an einem Gehäuse 102, beispielsweise an einem Gehäuse eines Wechselrichters, insbesondere eines Wechselrichters einer Antriebsvorrichtung für ein Elektro-Automobil, vorgesehen.

Der in den Zeichnungen beispielhaft dargestellte Gehäusedeckel 100 ist im Wesentlichen rechteckig ausgebildet und umfasst eine metallische Grundplatte 104 mit einem im Wesentlichen ebenen Mittelbereich 106 und mit einem gekrümmten Randbereich 108, der eine Biegung mit einem Biegewinkel von vorzugsweise mehr als 60°, beispielsweise von im Wesentlichen 90°, aufweist, um den Gehäusedeckel 100 an seinem äußeren Rand zu versteifen.

Der Randbereich 108 kann grundsätzlich zu dem zu verschließenden Gehäuse 102 hin oder von dem zu verschließenden Gehäuse 102 weg gebogen sein; in der zeichnerisch dargestellten Ausführungsform ist der gekrümmte Randbereich von dem mittels des Gehäusedeckels 100 zu verschließenden Gehäuse 102 weg gebogen.

Längs des äußeren Umfangs des Mittelbereichs 106 des Gehäusedeckels 100, in der Nähe des Übergangs zu dem gekrümmten Randbereich 108, ist der Gehäusedeckel 100 mit mehreren, im dargestellten Ausführungsbeispiel mit sechs, Befestigungsmittel-Durchtrittsöffnungen 110 versehen, welche längs des Umfangs des Gehäusedeckels im Abstand voneinander aufeinanderfolgen.

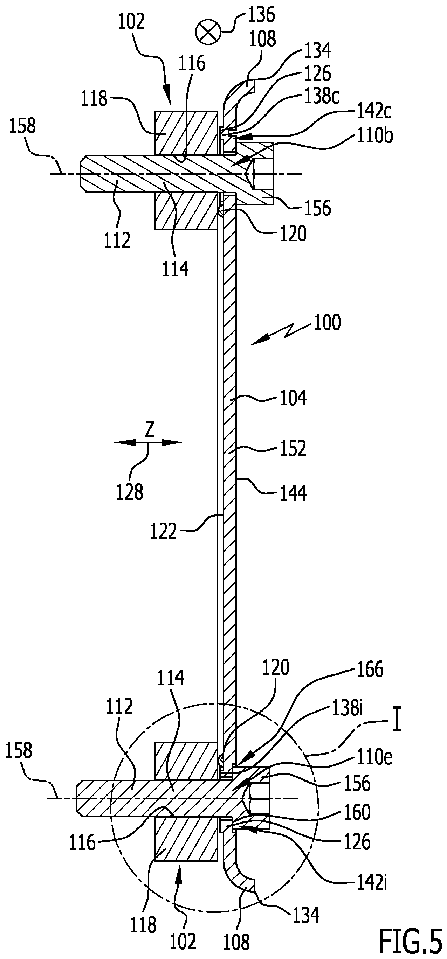

Diese Befestigungsmittel-Durchtrittsöffnungen 110 dienen bei der Montage des Gehäusedeckels 100 an dem zu verschließenden Gehäuse 102 zur Aufnahme der Schäfte 112 von Befestigungsschrauben 114 (siehe die Fig. 5, 7, 10, 13 und 15, welche den Gehäusedeckel 100 in seinem mittels der Befestigungsschrauben 114 an dem Gehäuse 102 montierten Zustand darstellen), welche sich durch die Befestigungsmittel-Durchtrittsöffnungen 110 hindurch erstrecken und mit ihren Außengewinden in korrespondierende Innengewinde von Gewindelöchern 116 in Befestigungsmittel-Montagebereichen 118 des zu verschließenden Gehäuses 102 eingeschraubt werden.

Zur fluiddichten Abdichtung zwischen dem Gehäusedeckel 100 und dem zu verschließenden Gehäuse 102 ist ein Dichtungswulst 120 vorgesehen, welcher an einer im montierten Zustand des Gehäusedeckels 100 dem Innenraum des zu verschließenden Gehäuses 102 zugewandten Innenseite des Gehäusedeckels 100, welche eine Dichtungstragefläche 122 des Gehäusedeckels 100 bildet, angeordnet ist.

Der Dichtungswulst 120 ist vorzugsweise ringförmig geschlossen ausgebildet.

Ein von dem Dichtungswulst 120 umgebener und von dem Dichtungswulst 120 berandeter Bereich 124 der Dichtungstragefläche 122 ist vorzugsweise im Wesentlichen eben ausgebildet.

Insbesondere kann vorgesehen sein, dass der gesamte von dem Dichtungswulst 120 umgebene Bereich 124 der Dichtungstragefläche 122 im Wesentlichen eben ausgebildet ist.

Der Dichtungswulst 120 ist aus einem Elastomermaterial, beispielsweise aus einem Silikonmaterial, gebildet und kann beispielsweise durch Auftragen mittels eines Dispensers (in einem sogenannten "Cured-in-Place"-Verfahren) oder durch ein Siebdruckverfahren an der Dichtungstragefläche 122 gebildet werden.

Bei der Montage des Gehäusedeckels 100 an dem Gehäuse 102 mittels der Befestigungsschrauben 114 wird der Dichtungswulst 120 durch Anziehen der Befestigungsschrauben 114 in den Gewindelöchern 116 der Befestigungsmittel-Montagebereiche 118 des Gehäuses 102 der Dichtungswulst 120 verpresst, wobei sich die Höhe h des Dichtungswulstes 120, das heißt dessen Ausdehnung senkrecht zu der Dichtungstragefläche 122, auf einen Wert h' verringert.

Die elastische Rückstellkraft des elastomeren Dichtungswulstes 120 erzeugt dann die Abdichtkraft, mit welcher der Dichtungswulst 120 abdichtend an dem Gehäuse 102 anliegt.

Um eine übermäßige Verformung des Dichtungswulstes 120 zu vermeiden, umfasst der Gehäusedeckel 100 ein oder mehrere Verformungsbegrenzungselemente 126, welche über die Dichtungstragefläche 122 in derselben Richtung, nämlich in einer senkrecht zur Dichtungstragefläche 122 ausgerichteten Z-Richtung 128, vorstehen wie der Dichtungswulst 120 und eine Verformung des Dichtungswulstes 120 im montierten Zustand des Gehäusedeckels 100 begrenzen.

Jedes Verformungsbegrenzungselement 126 ist steifer als der Dichtungswulst 120 ausgebildet, vorzugsweise im Wesentlichen starr, so dass die Höhe h' des Dichtungswulstes 120 im verpressten Zustand desselben nach unten durch die Höhe H des Verformungsbegrenzungselements 126 über der Dichtungstragefläche 122 begrenzt ist.

Jedes der Verformungsbegrenzungselemente 126 wird vorzugsweise durch einen Umformvorgang, insbesondere einen Prägevorgang oder einen Tiefziehvorgang, an der metallischen Grundplatte 104 des Gehäusedeckels 100, welche einen Grundkörper 152 des Gehäusedeckels 100 bildet, erzeugt.

Jedes Verformungsbegrenzungselement 126 ist beispielsweise als ein Vorsprung 130 ausgebildet, der sich in einer Längsrichtung 154 des Vorsprungs 130 erstreckt und der vorzugsweise einen oder mehrere Abschnitte 132 umfasst, welche sich im Wesentlichen parallel zu einem äußeren Rand 134 längs einer Umfangsrichtung 136 des Gehäusedeckels 100 erstrecken, und/oder einen oder mehrere Abschnitte 138 umfasst, welche sich im Wesentlichen längs einer Umfangsrichtung 140 jeweils einer Befestigungsmittel-Durchtrittsöffnung 110 erstrecken.

Dabei kann sich jeder Abschnitt 138 eines Verformungsbegrenzungselements 126 längs der Umfangsrichtung 140 der betreffenden Befestigungsmittel-Durchtrittsöffnung 110 über einen Umfangswinkel von mindestens 120°, vorzugsweise von mindestens 180°, insbesondere von mindestens 240°, erstrecken.

Ferner kann vorgesehen sein, dass ein Abschnitt 138 eines Verformungsbegrenzungselements 126 sich ringförmig geschlossen um eine Befestigungsmittel-Durchtrittsöffnung 110 herum erstreckt.

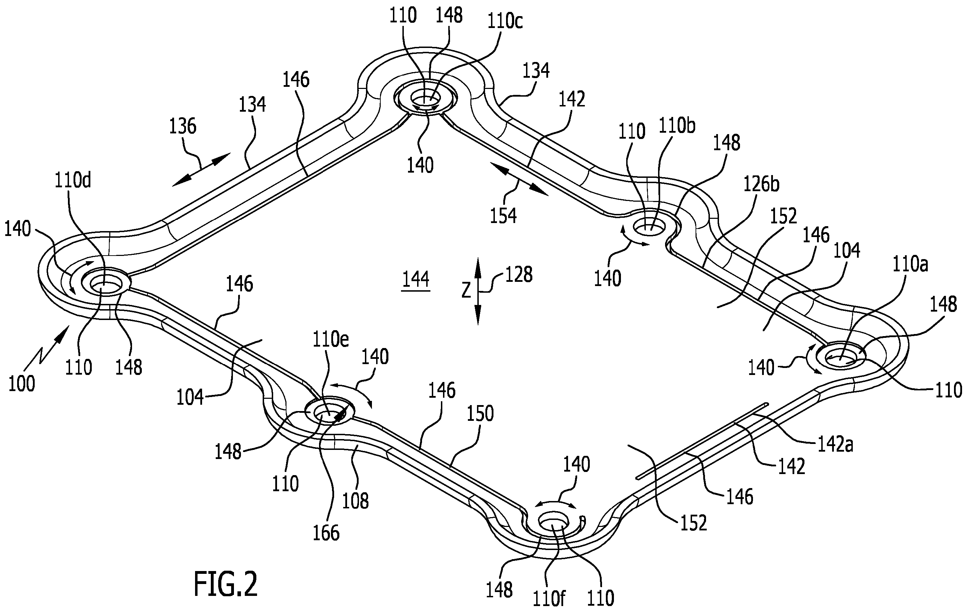

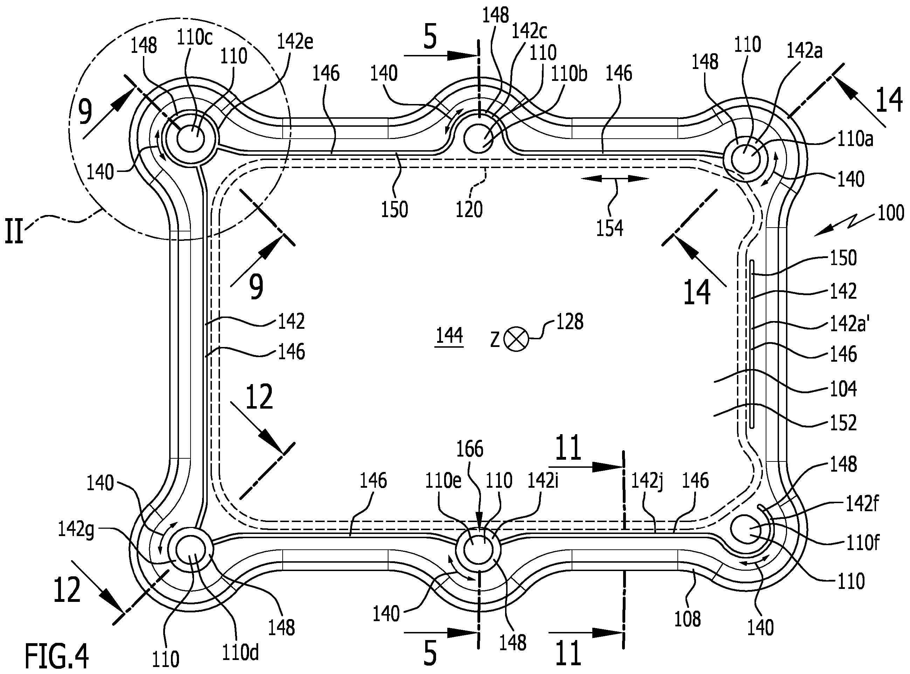

Da jedes Verformungsbegrenzungselement 126 vorzugsweise durch einen Umformvorgang erzeugt wird, bei welchem das Gesamtvolumen des Materials der metallischen Grundplatte 104 des Gehäusedeckels 100 im Wesentlichen erhalten bleibt, ist jedem als Vorsprung an der Dichtungstragefläche 122 ausgebildeten Verformungsbegrenzungselement 126 eine Vertiefung 142 zugeordnet, welche an der der Dichtungstragefläche 122 des Gehäusedeckels 100 abgewandten Außenseite 144 des Gehäusedeckels 100 ausgebildet ist (siehe Fig. 2 und 4).

Wie aus Fig. 2 zu ersehen ist, kann auch jede einem Verformungsbegrenzungselement 126 zugeordnete Vertiefung 142 einen oder mehrere Abschnitte 146 aufweisen, welche sich längs der Umfangsrichtung 136 des Gehäusedeckels 100 im Wesentlichen parallel zum äußeren Rand 134 des Gehäusedeckels 100 erstrecken, und einen oder mehrere Abschnitte 148 aufweisen, welche sich längs der Umfangsrichtung 140 einer Befestigungsmittel-Durchtrittsöffnung 110 erstrecken.

Dabei kann sich jeder Abschnitt 148 einer Vertiefung 142 längs der Umfangsrichtung 140 einer Befestigungsmittel-Durchtrittsöffnung 110 über einen Umfangswinkel von mindestens 120°, vorzugsweise von mindestens 180°, insbesondere von mindestens 240°, erstrecken.

Ferner kann vorgesehen sein, dass ein Abschnitt 148 einer Vertiefung 142 sich ringförmig geschlossen um eine Befestigungsmittel-Durchtrittsöffnung 110 herum erstreckt.

Die Abschnitte 146, 148 einer Vertiefung 142 an der Außenseite 144 des Gehäusedeckels 100 können insbesondere als eine Nut 150 ausgebildet sein.

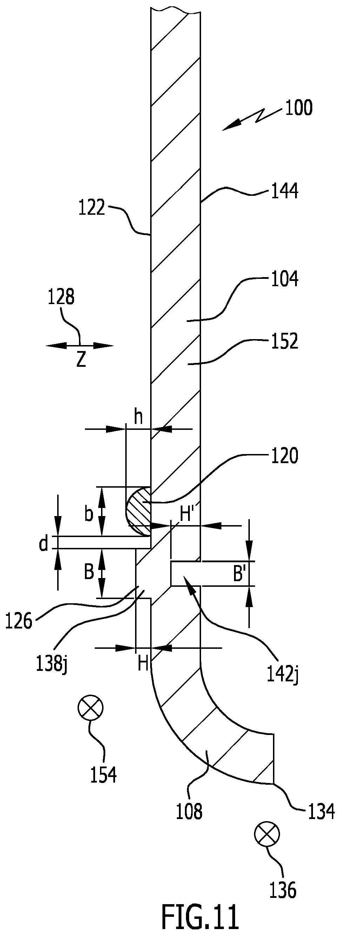

Wie beispielsweise aus Fig. 11 zu ersehen ist, kann die Breite B' einer Vertiefung 142, welche einem Verformungsbegrenzungselement 126 zugeordnet ist, von der Breite B des Verformungsbegrenzungselement 126 abweichen.

Ebenso kann die Tiefe H' der Vertiefung 142, das heißt deren Ausdehnung in der senkrecht zur Dichtungstragefläche 122 ausgerichteten Z-Richtung 128, von der Höhe H des zugeordneten Verformungsbegrenzungselements 126 abweichen.

Wie in Fig. 11 dargestellt, kann insbesondere die Breite B' der Vertiefung 142 kleiner sein als die Breite B des zugeordneten Verformungsbegrenzungselements 126.

Ferner kann die Tiefe H' der Vertiefung 142 größer sein als die Höhe H des zugeordneten Verformungsbegrenzungselements 126.

Alternativ hierzu könnte aber auch vorgesehen sein, dass die Breite B' der Vertiefung 142 größer ist als die Breite B des zugeordneten Verformungsbegrenzungselements 126.

Ferner könnte vorgesehen sein, dass die Tiefe H' der Vertiefung 142 kleiner ist als die Höhe H des zugeordneten Verformungsbegrenzungselements 126.

Die Breite B' und die Tiefe H' der Vertiefung 142 sowie die Breite B und die Höhe H des zugeordneten Verformungsbegrenzungselements 126 können durch die Gestaltung der für den Umformvorgang, bei welchem das Verformungsbegrenzungselement 126 und die zugeordnete Vertiefung 142 erzeugt werden, verwendeten Werkzeugteile in gewünschter Weise eingestellt werden.

So ist es insbesondere auch möglich, die Vertiefung 142 und das zugeordnete Verformungsbegrenzungselement 126 derart auszubilden, dass die Breite B' der Vertiefung 142 im Wesentlichen mit der Breite B des zugeordneten Verformungsbegrenzungselements 126 übereinstimmt und/oder dass die Tiefe H' der Vertiefung 142 im Wesentlichen mit der Höhe H des zugeordneten Verformungsbegrenzungselements 126 übereinstimmt.

Um zu gewährleisten, dass das Verformungsbegrenzungselement 126 die Verpressung des Dichtungswulstes 120 wirksam begrenzt, ist es günstig, wenn der Dichtungswulst 120 zumindest abschnittsweise in einem Abstand d von dem jeweils benachbarten Verformungsbegrenzungselement 126 verläuft, welcher kleiner ist als die Breite B des Verformungsbegrenzungselements 126 und/oder kleiner ist als die Breite b des Dichtungswulstes 120, insbesondere der Breite b des Dichtungswulstes 120 im unverpressten Zustand.

Ferner ist vorzugsweise vorgesehen, dass die Breite B des Verformungsbegrenzungselements 126 kleiner ist als das Vierfache, insbesondere kleiner ist als das Dreifache, besonders bevorzugt kleiner ist als das Doppelte, der Breite b des jeweils benachbarten Abschnitts des Dichtungswulstes 120.

Bei einer bevorzugten Ausgestaltung der Erfindung ist vorgesehen, dass die Breite B des Verformungsbegrenzungselements 126 im Wesentlichen gleich groß ist wie die Breite b des Dichtungswulstes 120.

Die Dichtungstragefläche 122 umfasst vorzugsweise einen im Wesentlichen ebenen Bereich, welcher den Dichtungswulst 120 trägt und auf der dem Verformungsbegrenzungselement 126 abgewandten Seite eine Breite aufweist, welche größer ist als die Breite b des Dichtungswulstes 120.

Hierdurch ist gewährleistet, dass die angestrebte Verringerung der Höhe h des Dichtungswulstes 120 auf die Höhe H des Verformungsbegrenzungselements 126 beim Verpressen des Gehäusedeckels 100 an dem Gehäuse 102 nicht durch eine auf der dem Verformungsbegrenzungselement 126 abgewandten Seite des Dichtungswulstes 120 angeordnete Struktur an der Dichtungstragefläche 122 behindert wird.

Die Grundplatte 104 des Gehäusedeckels 100 bildet den Grundkörper 152, welcher vorzugsweise als ein Blechformteil ausgebildet ist.

Der Grundkörper 152 des Gehäusedeckels 100 kann insbesondere Aluminium oder eine Aluminium-Legierung umfassen.

Um ein gleichmäßiges Anliegen des Gehäusedeckels 100 an dem zu verschließenden Gehäuse 102 zu gewährleisten, kann jedes Verformungsbegrenzungselement 126 mit einer sogenannten "Topographie" versehen werden, das heißt die zwischen jeweils zwei Befestigungsmittel-Durchtrittsöffnungen 110 liegenden Abschnitte 132 des jeweiligen Verformungsbegrenzungselements 126 werden so ausgebildet, dass sie eine in der Längsrichtung 154 des Verformungsbegrenzungselements 126 variierende Höhe H über der Dichtungstragefläche 122 aufweisen, wobei vorzugsweise die Höhe H des jeweiligen Verformungsbegrenzungselements 126 mit wachsendem Abstand von der nächstliegenden Befestigungsmittel-Durchtrittsöffnung 110 zunimmt.

Durch die so gestaltete Topographie des Verformungsbegrenzungselements 126 wird die Variation der Flächenpressung, mit welcher der Gehäusedeckel 100 gegen das zu verschließende Gehäuse 102 verspannt wird, in der Längsrichtung des Dichtungswulstes 120, welche aufgrund der variierenden Abstände von der jeweils nächstliegenden Befestigungsschraube 114 hervorgerufen wird, zumindest teilweise ausgeglichen und somit ein gleichmäßiges Anliegen des Dichtungswulstes 120 an dem zu verschließenden Gehäuse 102 an jeder Stelle des Dichtungswulstes 120 erzielt.

Diese Topographie des Verformungsbegrenzungselements 126 wird vorzugsweise während des Umformvorgangs erzeugt, bei welchem das betreffende Verformungsbegrenzungselement 126 gebildet wird.

Das in den Fig. 1 bis 15 dargestellte Ausführungsbeispiel eines Gehäusedeckels 100 umfasst verschiedene Formen von Verformungsbegrenzungselementen 126 und verschiedene Ausführungsformen für die Abschnitte 132 und 138 eines solchen Verformungsbegrenzungselements 126, welche im Folgenden im Einzelnen beschrieben werden.

Grundsätzlich ist es jedoch möglich, diese verschiedenen Ausgestaltungen von Verformungsbegrenzungselementen 126 sowie von Abschnitten 132 und 138 solcher Verformungsbegrenzungselemente 126 in beliebiger Weise an einem Gehäusedeckel 100 miteinander zu kombinieren.

Insbesondere kann auch vorgesehen sein, dass an einem Gehäusedeckel 100 nur eine einzige Art von Verformungsbegrenzungselementen 126 und/oder nur eine einzige Art von Abschnitten 132 eines Verformungsbegrenzungselements 126 und/oder nur eine einzige Art von Abschnitten 138 von Verformungsbegrenzungselementen 126 vorhanden ist.

Das zeichnerisch dargestellte Ausführungsbeispiel umfasst zwei Arten von Verformungsbegrenzungselementen 126, nämlich ein erstes Verformungsbegrenzungselement 126a, das beispielhaft nur einen einzigen Abschnitt 132 aufweist, welcher sich im Bereich zwischen zwei Befestigungsmittel-Durchtrittsöffnungen 110a und 110f (siehe Fig. 1) längs der Umfangsrichtung 136 des Gehäusedeckels 100 im Wesentlichen parallel zum äußeren Rand 134 des Gehäusedeckels 100 erstreckt.

Dieser Abschnitt 132 ist im Wesentlichen geradlinig ausgebildet und endet vorzugsweise an seinen beiden Enden im Abstand von der jeweils nächstliegenden Befestigungsmittel-Durchtrittsöffnung 110a beziehungsweise 110b.

Diesem ersten Verformungsbegrenzungselement 126a ist eine an der Außenseite 144 des Gehäusedeckels 100 angeordnete erste Vertiefung 142a' zugeordnet, die ebenfalls nur einen, vorzugsweise im Wesentlichen geradlinig ausgebildeten, Abschnitt 146 aufweist, welcher sich längs der Umfangsrichtung 136 des Gehäusedeckels 100 und im Wesentlichen parallel zum äußeren Rand 134 des Gehäusedeckels 100 erstreckt.

Die erste Vertiefung 142a' endet vorzugsweise an ihren beiden Enden im Abstand von der jeweils nächstliegenden Befestigungsmittel-Durchtrittsöffnung 110a beziehungsweise 110b.

Die Breite B' der ersten Vertiefung 142a' ist vorzugsweise kleiner als die Breite B des ersten Verformungsbegrenzungselements 126a.

Die Tiefe H' der ersten Vertiefung 142a' ist vorzugsweise größer als die Höhe H des ersten Verformungsbegrenzungselements 126a.

Das in den Zeichnungen dargestellte Ausführungsbeispiel für einen Gehäusedeckel 100 umfasst ferner ein zweites Verformungsbegrenzungselement 126b, das beispielhaft folgende Abschnitte umfasst:
einen ersten Abschnitt 138a, welcher sich über einen Umfangswinkel von vorzugsweise mehr als 240° und vorzugsweise weniger als 300° um die erste Befestigungsmittel-Durchtrittsöffnung 110a herum erstreckt;
einen sich im Wesentlichen längs der Umfangsrichtung 136 des Gehäusedeckels 100 zwischen der ersten Befestigungsmittel-Durchtrittsöffnung 110a und einer zweiten Befestigungsmittel-Durchtrittsöffnung 110b erstreckenden zweiten Abschnitt 132b;
einen sich längs der Umfangsrichtung 140 über einen Umfangswinkel von ungefähr 180° um die zweite Befestigungsmittel-Durchtrittsöffnung 110b herum erstreckenden dritten Abschnitt 138c;
einen sich im Bereich zwischen der zweiten Befestigungsmittel-Durchtrittsöffnung 110b und einer dritten Befestigungsmittel-Durchtrittsöffnung 110c längs der Umfangsrichtung 136 des Gehäusedeckels 100 erstreckenden vierten Abschnitt 132d;
einen sich längs der Umfangsrichtung 140 der dritten Befestigungsmittel-Durchtrittsöffnung 110c ringförmig geschlossen um die dritte Befestigungsmittel-Durchtrittsöffnung 110c herum erstreckenden fünften Abschnitt 138e; einen sich im Bereich zwischen der dritten Befestigungsmittel-Durchtrittsöffnung 110c und einer vierten Befestigungsmittel-Durchtrittsöffnung 110d längs der Umfangsrichtung 136 des Gehäusedeckels 100 erstreckenden sechsten Abschnitt 132f;
einen sich längs der Umfangsrichtung 140 der vierten Befestigungsmittel-Durchtrittsöffnung 110d ringförmig geschlossen um die vierte Befestigungsmittel-Durchtrittsöffnung 110d herum erstreckenden siebten Abschnitt 138g; einen sich zwischen der vierten Befestigungsmittel-Durchtrittsöffnung 110d und einer fünften Befestigungsmittel-Durchtrittsöffnung 110e längs der Umfangsrichtung 136 des Gehäusedeckels 100 erstreckenden achten Abschnitt 132h;
einen sich längs der Umfangsrichtung 140 der fünften Befestigungsmittel-Durchtrittsöffnung 110e ringförmig geschlossen um die fünfte Befestigungsmittel-Durchtrittsöffnung 110e herum erstreckenden neunten Abschnitt 138i; einen sich zwischen der fünften Befestigungsmittel-Durchtrittsöffnung 110e und einer sechsten Befestigungsmittel-Durchtrittsöffnung 110f längs der Umfangsrichtung 136 des Gehäusedeckels 100 erstreckenden zehnten Abschnitt 138j; und
einen sich längs der Umfangsrichtung 140 der sechsten Befestigungsmittel-Durchtrittsöffnung 110f über einen Umfangswinkel von vorzugsweise mindestens 180° und vorzugsweise weniger als 300° um die sechste Befestigungsmittel-Durchtrittsöffnung 110f herum erstreckenden elften Abschnitt 138k.

Das zweite Verformungsbegrenzungselement 126b endet im ersten Abschnitt 138a und im elften Abschnitt 138k jeweils im Abstand von den jeweils zugewandten Enden des ersten Verformungsbegrenzungselements 126a.

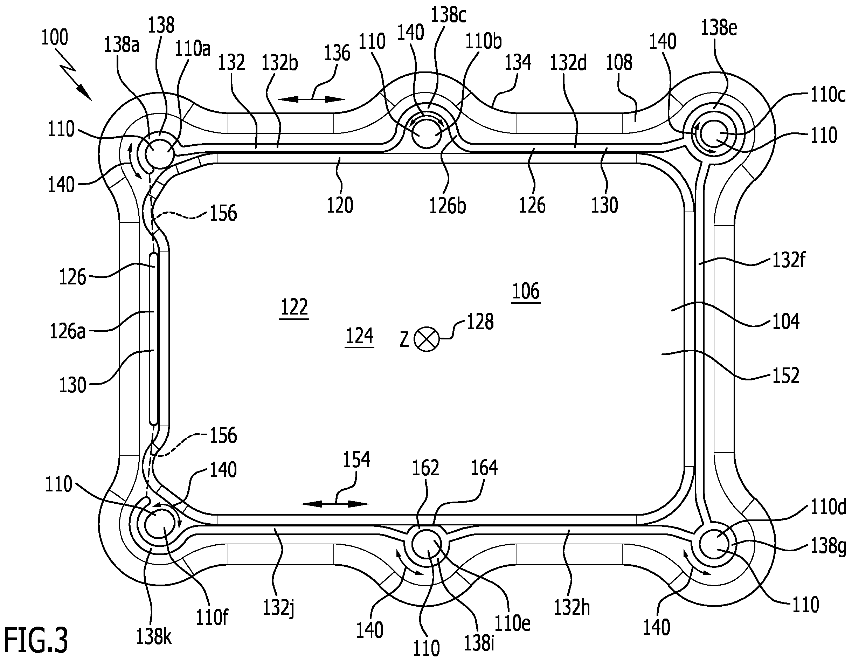

Wie insbesondere aus Fig. 3 zu ersehen ist, überquert dabei vorzugsweise der Dichtungswulst 120 die in Fig. 3 gebrochen dargestellten Verbindungslinien 156 zwischen den Endpunkten des ersten Verformungsbegrenzungselements 126a und den Endpunkten des zweiten Verformungsbegrenzungselements 126b, was zur Folge hat, dass die diesen Bereichen des Dichtungswulstes 120 benachbarten Verformungsbegrenzungselemente 126a, 126b auch in dem Bereich des Umfangs des Gehäusedeckels 100, in welchem kein Verformungsbegrenzungselement 126 ausgebildet ist, eine möglichst hohe Verformungsbegrenzungswirkung auf den Dichtungswulst 120 ausüben.

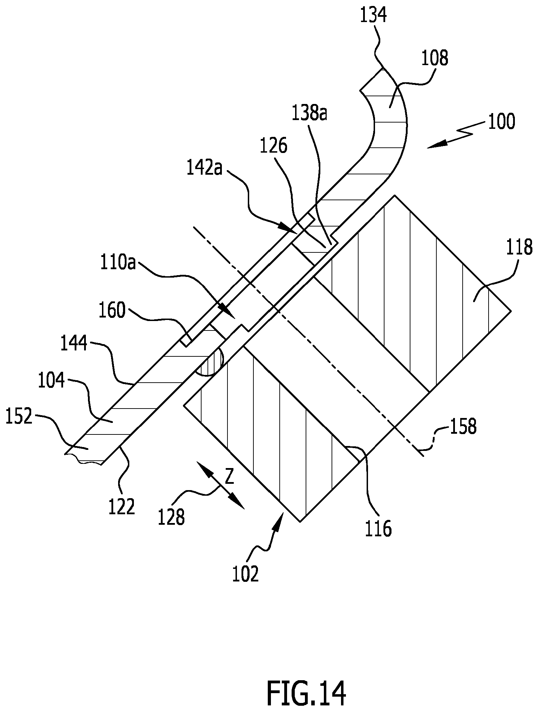

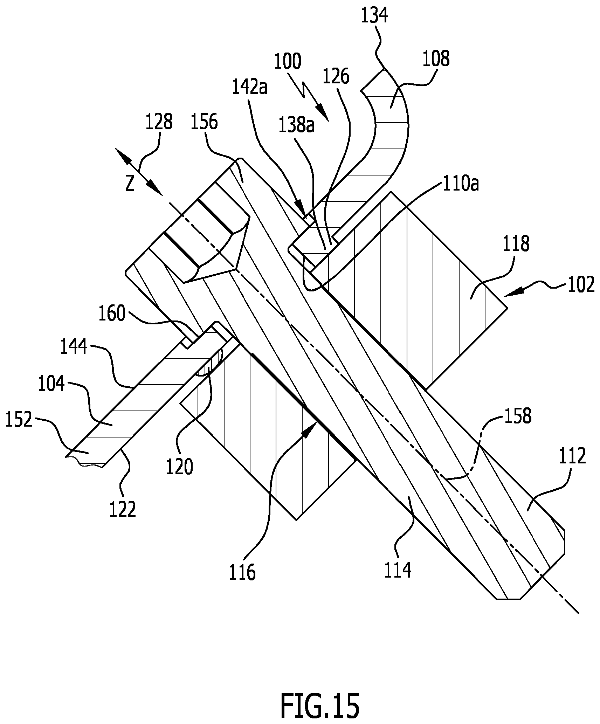

Wie am besten aus den Fig. 14 und 15 zu ersehen ist, erstreckt sich der Abschnitt 138a des Verformungsbegrenzungselements 126b bis unmittelbar an den Rand der Befestigungsmittel-Durchtrittsöffnung 110a heran, so dass im montierten Zustand des Gehäusedeckels 100 (siehe Fig. 15) zumindest ein Teil des Verformungsbegrenzungselements 126 zwischen dem Kopf 156 der zugehörigen Befestigungsschraube 114 und dem Gehäuse 102 eingeklemmt ist und auf Block verpresst wird.

Die dem Abschnitt 138a des Verformungsbegrenzungselements 126b zugeordnete Vertiefung 142a ist vorzugsweise im Wesentlichen rotationssymmetrisch zur Längsmittelachse 158 der Befestigungsmittel-Durchtrittsöffnung 110a ausgebildet und reicht bis an den Rand der Befestigungsmittel-Durchtrittsöffnung 110a heran, so dass die Befestigungsmittel-Durchtrittsöffnung 110a in der Vertiefung 142a mündet.

Im montierten Zustand des Gehäusedeckels 100 liegt die Befestigungsschraube 114, vorzugsweise im Wesentlichen flächig, an einem die Befestigungsmittel-Durchtrittsöffnung 110a umgebenden Boden 160 der Vertiefung 142a an.

Der Dichtungswulst 120 überlappt zumindest teilweise - in der Z-Richtung 128 gesehen - mit einem Teil der Vertiefung 142a, welchem an der Dichtungstragefläche 122 kein Bereich des Verformungsbegrenzungselements 126 gegenüberliegt, und mit dem Kopf 156 der Befestigungsschraube 114.

Hierdurch wird zumindest ein Teil des Dichtungswulstes 120 direkt zwischen dem Kopf 156 der Befestigungsschraube 114 und dem Gehäuse 102 verpresst, was eine besonders hohe Anpresskraft des Dichtungswulstes 120 in diesem Bereich und damit eine besonders hohe Abdichtkraft zur Folge hat.

Ein anderer Teil des Dichtungswulstes 120 erstreckt sich in der Radialrichtung der Befestigungsmittel-Durchtrittsöffnung 110a nach außen über die Vertiefung 142a und über den Kopf 156 der Befestigungsschraube 114 hinaus.

Im Abschnitt 138c des Verformungsbegrenzungselements 126b erstrecken sich, wie aus dem oberen Teil von Fig. 5 zu ersehen ist, das Verformungsbegrenzungselement 126 und/oder die demselben zugeordnete Vertiefung 142c nicht bis unmittelbar an den Rand der Befestigungsmittel-Durchtrittsöffnung 110b.

Im montierten Zustand des Gehäusedeckels 100 liegen daher vorzugsweise das Verformungsbegrenzungselement 126 und/oder die demselben zugeordnete Vertiefung 142 radial (bezogen auf die Längsmittelachse 158 der Befestigungsmittel-Durchtrittsöffnung 110b) außerhalb des Kopfes 156 der Befestigungsschraube 114.

Vorzugsweise liegt im Bereich der Befestigungsmittel-Durchtrittsöffnung 110b auch der Dichtungswulst 120 radial außerhalb des Kopfes 156 der Befestigungsschraube 114.

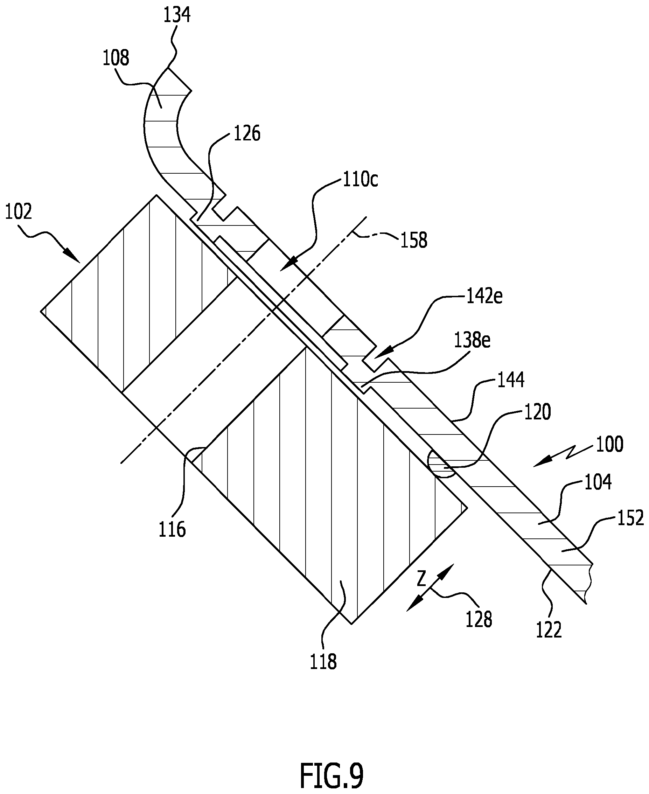

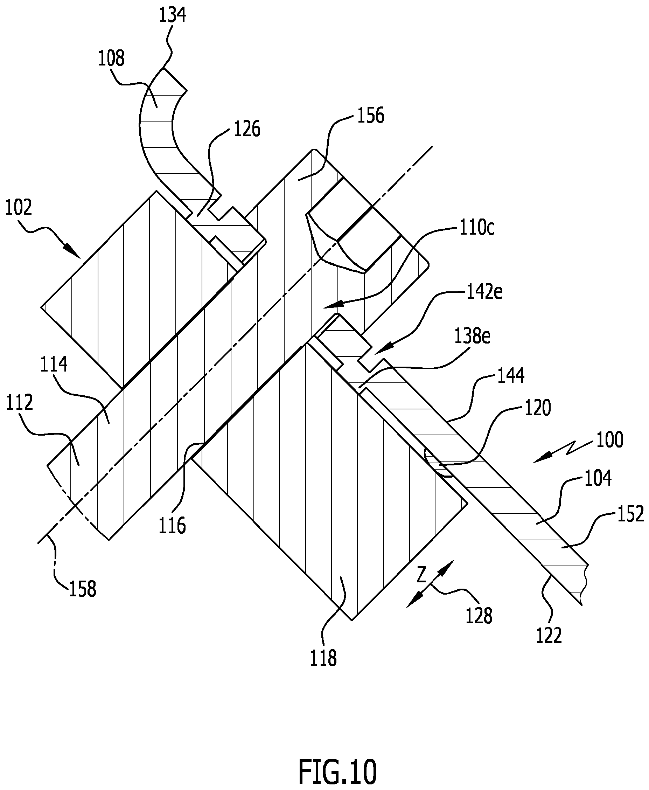

Der Abschnitt 138e des Verformungsbegrenzungselements 126b erstreckt sich im Abstand von dem Rand der Befestigungsmittel-Durchtrittsöffnung 110c ringförmig geschlossen um die Befestigungsmittel-Durchtrittsöffnung 110c herum (siehe die Fig. 9 und 10).

Auch die dem Verformungsbegrenzungselement 126 zugeordnete Vertiefung 142 verläuft im Abstand von der Befestigungsmittel-Durchtrittsöffnung 110c ringförmig geschlossen um dieselbe herum.

Im montierten Zustand des Gehäusedeckels 100 liegen vorzugsweise das Verformungsbegrenzungselement 126 und/oder die dem Verformungsbegrenzungselement 126 zugeordnete Vertiefung 142 im Bereich der Befestigungsmittel-Durchtrittsöffnung 110c radial (bezogen auf die Längsmittelachse 158 der Befestigungsmittel-Durchtrittsöffnung 110c) außerhalb des Kopfes 156 der Befestigungsschraube 114.

Der Dichtungswulst 120 ist im Bereich der Befestigungsmittel-Durchtrittsöffnung 110c radial außerhalb des Verformungsbegrenzungselements 126 und/oder radial außerhalb der dem Verformungsbegrenzungselement 126 zugeordneten Vertiefung 142 angeordnet.

Im Bereich der Befestigungsmittel-Durchtrittsöffnung 110d erstreckt sich der Abschnitt 138g des Verformungsbegrenzungselements 126b ringförmig geschlossen um die Befestigungsmittel-Durchtrittsöffnung 110d herum.

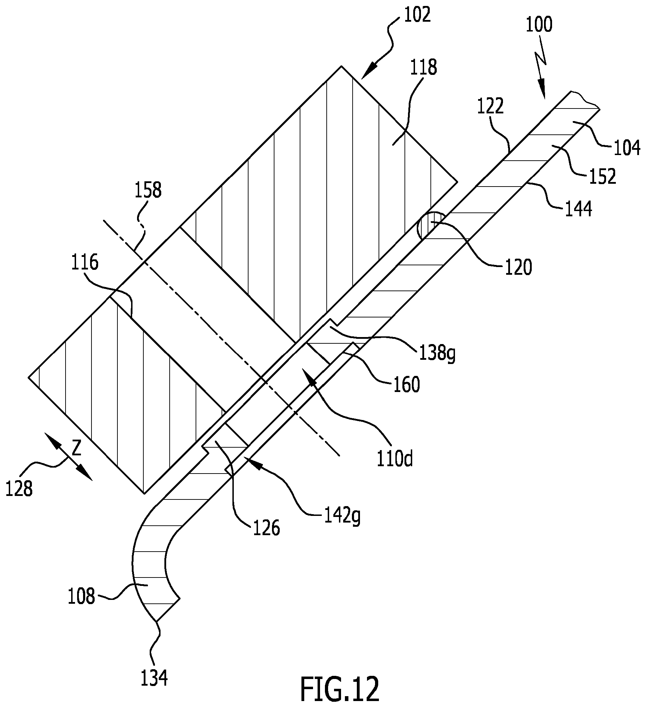

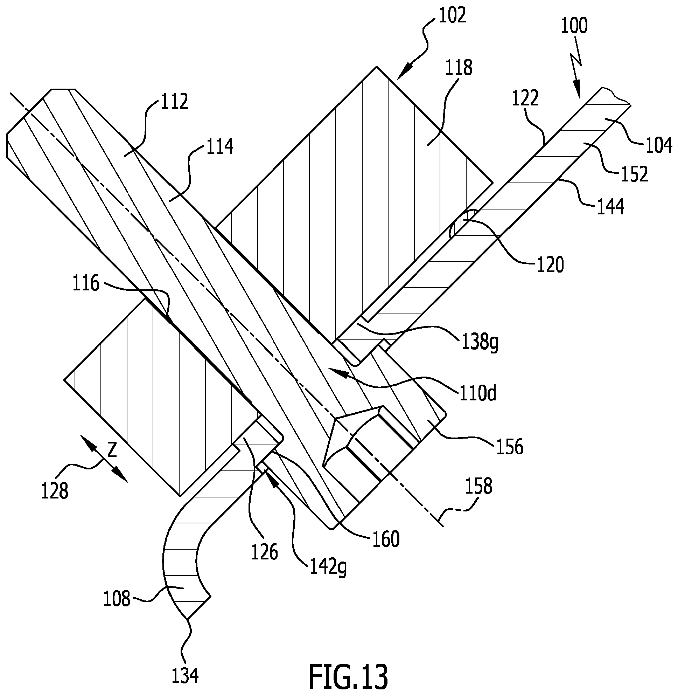

Dabei reicht das Verformungsbegrenzungselement 126 bis unmittelbar an den Rand der Befestigungsmittel-Durchtrittsöffnung 110d heran (siehe die Fig. 12 und 13).

Die dem Verformungsbegrenzungselement 126 zugeordnete Vertiefung 142g ist im Wesentlichen rotationssymmetrisch zur Längsmittelachse 158 der Befestigungsmittel-Durchtrittsöffnung 110d ausgebildet.

Die Befestigungsmittel-Durchtrittsöffnung 110d mündet in die Vertiefung 142g.

Das Verformungsbegrenzungselement 126 ist im verpressten Zustand des Gehäusedeckels 100 (siehe Fig. 13) zwischen dem Kopf 156 der Befestigungsschraube 114 und dem Gehäuse 102 angeordnet und wird von der Befestigungsschraube 114 unmittelbar auf Block verpresst.

Der Dichtungswulst 120 liegt im Bereich der Befestigungsmittel-Durchtrittsöffnung 110d radial (bezogen auf die Längsmittelachse 158 der Befestigungsmittel-Durchtrittsöffnung 110d) außerhalb des Kopfes 156 der Befestigungsschraube 114.

Im Bereich der Befestigungsmittel-Durchtrittsöffnung 110e erstreckt sich der Abschnitt 138i des Verformungsbegrenzungselements 126b ringförmig geschlossen um die Befestigungsmittel-Durchtrittsöffnung 110e herum.

Das Verformungsbegrenzungselement 126 erstreckt sich bis unmittelbar an den Rand der Befestigungsmittel-Durchtrittsöffnung 110e heran (siehe den unteren Teil von Fig. 5 sowie die Fig. 6 und 7).

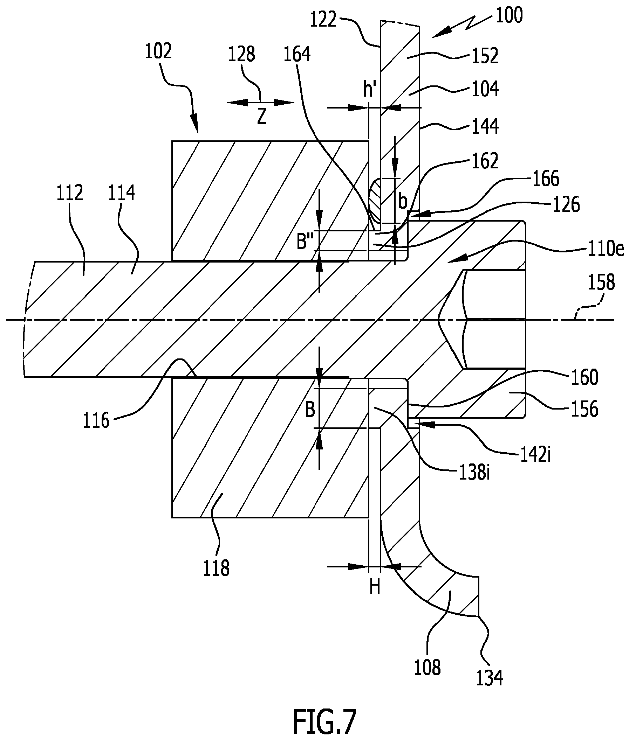

Im verpressten Zustand des Gehäusedeckels 100 (siehe Fig. 7) ist zumindest ein Teil des Verformungsbegrenzungselements 126 zwischen dem Kopf 156 der Befestigungsschraube 114 und dem Gehäuse 102 angeordnet, so dass das Verformungsbegrenzungselement 126 unmittelbar von der Befestigungsschraube 114 auf Block verpresst wird.

Die dem Verformungsbegrenzungselement 126 zugeordnete Vertiefung 142i ist im Wesentlichen rotationssymmetrisch zur Längsmittelachse 158 der Befestigungsmittel-Durchtrittsöffnung 110e ausgebildet.

Die Befestigungsmittel-Durchtrittsöffnung 110e mündet in die Vertiefung 142i.

Im verpressten Zustand des Gehäusedeckels 100 (siehe Fig. 7) liegt der Kopf 156 der Befestigungsschraube 114 am Boden 160 der Vertiefung 142i an.

Das Verformungsbegrenzungselement 126 weist in einem Bereich 162, welcher zwischen der Befestigungsmittel-Durchtrittsöffnung 110e einerseits und dem Dichtungswulst 120 andererseits liegt, eine verringerte Breite B" auf, was es ermöglicht, den Dichtungswulst 120 in diesem Bereich möglichst nah an die Befestigungsmittel-Durchtrittsöffnung 110e und an die Befestigungsschraube 114 heranzuführen.

Ferner kann das Verformungsbegrenzungselement 126 in diesem Bereich 162 einen im Wesentlichen geradlinigen, vorzugsweise im Wesentlichen parallel zum Dichtungswulst 120 verlaufenden, Rand 164 aufweisen.

Die dem Verformungsbegrenzungselement 126 zugeordnete und sich um dieselbe Befestigungsmittel-Durchtrittsöffnung 110 herum erstreckende Vertiefung 142 umfasst einen (vorzugsweise kreiszylinderabschnittsförmigen) Bereich 166, welcher - in der Z-Richtung 128 gesehen - nicht mit dem Verformungsbegrenzungselement 126 überlappt.

Um zu vermeiden, dass die verringerte Breite B" des Verformungsbegrenzungselements 126 in dem Bereich 162 zu einer unzulässig hohen Flächenpressung im montierten Zustand des Gehäusedeckels 100 führt, kann vorgesehen sein, dass ein anderer Bereich des Verformungsbegrenzungselements 126, welcher sich um dieselbe Befestigungsmittel-Durchtrittsöffnung 110e herum erstreckt, eine größere Breite aufweist, und/oder dass das Verformungsbegrenzungselement 126 einen Bereich umfasst, welcher sich in einer im Wesentlichen parallel zum Dichtungswulst 120 verlaufenden Richtung an den Bereich 162 des Verformungsbegrenzungselements 126, welcher eine verringerte Breite B'' aufweist, anschließt.

Der Dichtungswulst 120 überlappt sich - in der Z-Richtung 128 gesehen - vorzugsweise mit der Vertiefung 142i und/oder mit dem Kopf 156 der Befestigungsschraube 114 (siehe Fig. 7).

Dies ermöglicht es, den Dichtungswulst 120 in diesem Bereich mit einer besonders hohen Anpresskraft zu beaufschlagen und somit eine besonders hohe Abdichtkraft zu erzeugen.

Verschiedene alternative Ausführungsformen des Abschnitts 138i des Verformungsbegrenzungselements 126b sind in den Fig. 16 bis 19 dargestellt.

Dabei kann dieser Abschnitt 138i des Verformungsbegrenzungselements 126 von den benachbarten Abschnitten 132h und/oder 132i des Verformungsbegrenzungselements 126 beabstandet oder mit denselben verbunden sein.

Der Abschnitt 138i des Verformungsbegrenzungselements 126, welcher sich längs der Umfangsrichtung 140 der Befestigungsmittel-Durchtrittsöffnung 110e ganz oder teilweise um die Befestigungsmittel-Durchtrittsöffnung 110 herum erstreckt, kann eine maximale Breite B und eine minimale Breite B'' aufweisen (siehe Fig. 16). Die Breite B beziehungsweise B" entspricht dabei dem Abstand zwischen einem der Befestigungsmittel-Durchtrittsöffnung zugewandten inneren Rand 168 und einem der Befestigungsmittel-Durchtrittsöffnung abgewandten äußeren Rand 170 des Abschnitts 138i des Verformungsbegrenzungselements 126.

Der innere Rand 168 des Abschnitts 138i des Verformungsbegrenzungselements 126 kann dabei mit dem Rand 172 der Befestigungsmittel-Durchtrittsöffnung 110 zusammenfallen.

Die maximale Breite B des Abschnitts 138i des Verformungsbegrenzungselements 126 beträgt vorzugsweise höchstens 100 % des Durchmessers D der Befestigungsmittel-Durchtrittsöffnung 110, insbesondere höchstens 60 % des Durchmessers D der Befestigungsmittel-Durchtrittsöffnung 110, besonders bevorzugt höchstens 20 % des Durchmessers D der Befestigungsmittel-Durchtrittsöffnung 110.

Die minimale Breite B" des Abschnitts 138i des Verformungsbegrenzungselements 126 beträgt vorzugsweise weniger als 50 % der maximalen Breite B des Abschnitts 138i des Verformungsbegrenzungselements 126.

Bei der in Fig. 17 dargestellten alternativen Ausführungsform sind den inneren Rand 168 und den äußeren Rand 170 des Abschnitts 138i des Verformungsbegrenzungselements 126 miteinander verbindende Randabschnitte 174 im Wesentlichen tangential zu der Befestigungsmittel-Durchtrittsöffnung 110 angeordnet. In diesem Fall ist die minimale Breite B'' des Abschnitts 138i des Verformungsbegrenzungselements 126 gleich null.

Bei der in Fig. 18 dargestellten alternativen Ausführungsform erstreckt sich der innere Rand 168 des Abschnitts 138i des Verformungsbegrenzungselements 126 über einen Umfangswinkel α (bezogen auf die Mittelachse 176 der Befestigungsmittel-Durchtrittsöffnung 110) von 360° oder weniger, vorzugsweise von 320° oder weniger, insbesondere von 270° oder weniger, besonders bevorzugt von 180° oder weniger.

Der äußere Rand 170 des Abschnitts 138i des Verformungsbegrenzungselements 126 erstreckt sich über einen Umfangswinkel β (bezogen auf die Mittelachse 176 der Befestigungsmittel-Durchtrittsöffnung 110) von 360° oder weniger, vorzugsweise von 320° oder weniger, insbesondere von 270° oder weniger, besonders bevorzugt von 180° oder weniger.

Der Umfangswinkel α, längs welchem sich der innere Rand 168 des Abschnitts 138i des Verformungsbegrenzungselements 126 um die Befestigungsmittel-Durchtrittsöffnung 110 herum erstreckt, kann, wie in den Fig. 16 und 17 gezeigt, im Wesentlichen gleich groß sein wie der Umfangswinkel β, längs welchem sich der äußere Rand 170 des Abschnitts 138i des Verformungsbegrenzungselements 126 um die Befestigungsmittel-Durchtrittsöffnung 110 herum erstreckt. In diesem Fall können die Randabschnitte 174, welche den inneren Rand 168 und den äußeren Rand 170 des Abschnitts 138i des Verformungsbegrenzungselements 126 miteinander verbinden, im Wesentlichen radial zur Mittelachse 176 der Befestigungsmittel-Durchtrittsöffnung 110 ausgerichtet sein.

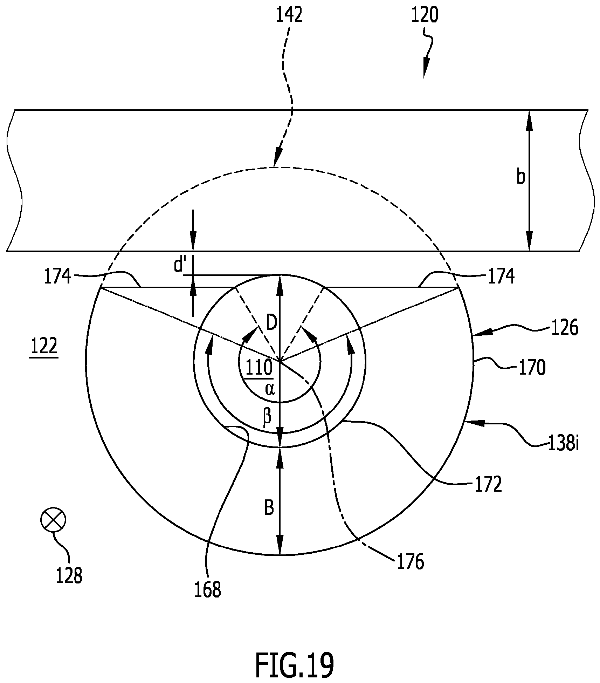

Bei den in den Fig. 18 und 19 dargestellten Ausgestaltungen des Verformungsbegrenzungselements 126 ist hingegen vorgesehen, dass der Umfangswinkel α größer ist als der Umfangswinkel β. In diesem Fall sind die Randabschnitte 174 des Verformungsbegrenzungselements 126, welche den inneren Rand 168 mit dem äußeren Rand 170 des Verformungsbegrenzungselements 126 verbinden, nicht-radial in Bezug auf die Mittelachse 176 der Befestigungsmittel-Durchtrittsöffnung 110 ausgerichtet.

Bei der in Fig. 19 dargestellten Ausführungsform ist vorgesehen, dass die Randabschnitte 174 des Abschnitts 138i des Verformungsbegrenzungselements 126, welche den inneren Rand 168 und den äußeren Rand 170 des Abschnitts 138i des Verformungsbegrenzungselements 126 miteinander verbinden, im Wesentlichen parallel zu dem Dichtungswulst 120 ausgerichtet sind.

Der Abstand d des Dichtungswulstes 120 von dem Abschnitt 138i des Verformungsbegrenzungselements 126 beträgt vorzugsweise mindestens 0,5 mm, insbesondere mindestens 0,7 mm, besonders bevorzugt mindestens 1,0 mm.

Wenn der Abschnitt 138i des Verformungsbegrenzungselements 126 sich nicht vollständig um die Befestigungsmittel-Durchtrittsöffnung 110 herum erstreckt, so ist vorzugsweise der Abstand d' des Dichtungswulstes 120 von dem Rand 172 der Befestigungsmittel-Durchtrittsöffnung 110 abschnittsweise kleiner als der Abstand d des Dichtungswulstes 120 von dem Verformungsbegrenzungselement 126 (siehe die Fig. 18 und 19).

In diesem Fall beträgt der Abstand d' des Dichtungswulstes 120 von dem Rand 172 der Befestigungsmittel-Durchtrittsöffnung 110 vorzugsweise mindestens 0,5 mm, insbesondere mindestens 0,7 mm, besonders bevorzugt mindestens 1,0 mm.

Im Abschnitt 132j des Verformungsbegrenzungselements 126b verläuft das Verformungsbegrenzungselement 126 im Wesentlichen parallel zu dem Dichtungswulst 120 und/oder im Wesentlichen parallel zu einem äußeren Rand 134 des Gehäusedeckels 100 (siehe die Fig. 1 und 3).

Der Abstand d zwischen dem Dichtungswulst 120 und dem Verformungsbegrenzungselement 126 ist in diesem Abschnitt vorzugsweise kleiner als die Breite b des Dichtungswulstes 120 und/oder vorzugsweise kleiner als die Breite B des Verformungsbegrenzungselements 126 (siehe Fig. 11).

Im Bereich der Befestigungsmittel-Durchtrittsöffnung 110f verläuft das Verformungsbegrenzungselement 126 im Abstand vom Rand der Befestigungsmittel-Durchtrittsöffnung 110f (siehe Fig. 3).

Auch die dem Verformungsbegrenzungselement 126 zugeordnete Vertiefung 142k reicht nicht bis an den Rand der Befestigungsmittel-Durchtrittsöffnung 110f heran (siehe Fig. 4).

Zur Herstellung des vorstehend beschriebenen Gehäusedeckels 100 wird beispielsweise wie folgt vorgegangen:
In einem Folgeverbundwerkzeug wird aus einem Blech eines metallischen Materials, insbesondere aus einem Aluminiumblech, der Gehäusedeckel 100 mit der gewünschten Außenkontur und den Befestigungsmittel-Durchtrittsöffnungen 110 ausgestanzt.

Ferner wird der Gehäusedeckel 100 in dem Folgeverbundwerkzeug durch geeignete Umformwerkzeuge mit den Verformungsbegrenzungselementen 126 und den denselben zugeordneten Vertiefungen 142, gegebenenfalls mit der vorstehend beschriebenen Topographie der Verformungsbegrenzungselemente 126, versehen.

Anschließend wird durch ein Dispenser-Auftrags-Verfahren ("Cured-in-Place"-Verfahren) oder durch ein Siebdruckverfahren der Dichtungswulst 120 aus dem Elastomermaterial an der Dichtungstragefläche 122 erzeugt.

Der Gehäusedeckel 100 eignet sich insbesondere zum Verschließen eines Gehäuses 102 eines Wechselrichters, insbesondere eines Wechselrichters einer elektrischen Antriebsvorrichtung, beispielsweise einer elektrischen Antriebsvorrichtung eines Elektro-Automobils.

## Patentansprüche

1. Gehäusedeckel zum Festlegen an einem Gehäuse (102), insbesondere an einem Wechselrichter-Gehäuse,
wobei der Gehäusedeckel (100) mit mehreren Befestigungsmittel-Durchtrittsöffnungen (110) und mit einem Dichtungswulst (120), der ein elastomeres Material umfasst, versehen ist,
wobei der Dichtungswulst (120) an einer Dichtungstragefläche (122) des Gehäusedeckels (100) angeordnet ist,
wobei der Gehäusedeckel (100) mindestens ein Verformungsbegrenzungselement (126) umfasst, welches über die Dichtungstragefläche (122) in derselben Richtung (128) vorsteht wie der Dichtungswulst (120) und eine Verformung des Dichtungswulstes (120) im montierten Zustand des Gehäusedeckels (100) begrenzt, und
wobei mindestens ein Abschnitt (138a, 138c, 138e, 138g, 138i, 138k) mindestens eines Verformungsbegrenzungselements (126) sich längs der Umfangsrichtung (140) einer Befestigungsmittel-Durchtrittsöffnung (110) um einen Umfangswinkel von mindestens 160° um die Befestigungsmittel-Durchtrittsöffnung (110) herum erstreckt,
**dadurch gekennzeichnet,**
**dass** dem Verformungsbegrenzungselement (126) eine Vertiefung (142) an der der Dichtungstragefläche (122) abgewandten Außenseite (144) des Gehäusedeckels (100) zugeordnet ist.

2. Gehäusedeckel nach Anspruch 1, **dadurch gekennzeichnet, dass** das Verformungsbegrenzungselement (126) durch Umformung eines Grundkörpers (152) des Gehäusedeckels (100) erzeugt ist.

3. Gehäusedeckel nach einem der Ansprüche 1 oder 2, **dadurch gekennzeichnet, dass** mindestens ein Abschnitt (138e, 138g, 138i) mindestens eines Verformungsbegrenzungselements (126) sich ringförmig geschlossen um eine Befestigungsmittel-Durchtrittsöffnung (110c, 110d, 110e) herum erstreckt.

4. Gehäusedeckel nach einem der Ansprüche 1 bis 3, **dadurch gekennzeichnet, dass** mindestens ein Abschnitt (138) mindestens eines Verformungsbegrenzungselements (126) auf einer dem Dichtungswulst (120) abgewandten Seite einer Befestigungsmittel-Durchtrittsöffnung (110) angeordnet ist,
wobei vorzugsweise der mindestens eine Abschnitt (138) des mindestens einen Verformungsbegrenzungselements (126) zwischen der Befestigungsmittel-Durchtrittsöffnung (110) und einem äußeren Rand (134) des Gehäusedeckels (100) angeordnet ist.

5. Gehäusedeckel nach einem der Ansprüche 1 bis 4, **dadurch gekennzeichnet, dass** an dem Gehäusedeckel (100) mehrere Verformungsbegrenzungselemente (126) vorgesehen sind, welche sich längs einer Umfangsrichtung (136) des Gehäusedeckels (100) erstrecken und längs der Umfangsrichtung (136) voneinander beabstandet sind.

6. Gehäusedeckel nach einem der Ansprüche 1 bis 5, **dadurch gekennzeichnet, dass** der Dichtungswulst (120) ringförmig geschlossen ausgebildet ist,
wobei vorzugsweise ein von dem Dichtungswulst (120) umgebener Bereich (124) der Dichtungstragefläche (122) im Wesentlichen eben ausgebildet ist.

7. Gehäusedeckel nach einem der Ansprüche 1 bis 6, **dadurch gekennzeichnet, dass** das Verformungsbegrenzungselement (126) einen sich in einer Längsrichtung (154) des Verformungsbegrenzungselements (126) erstreckenden Vorsprung (130) umfasst.

8. Gehäusedeckel nach einem der Ansprüche 1 bis 7, **dadurch gekennzeichnet, dass** mindestens eine Befestigungsmittel-Durchtrittsöffnung (110a, 110d, 110e) des Gehäusedeckels (100) in eine Vertiefung (142a, 142g, 142i), die einem Verformungsbegrenzungselement (126) zugeordnet ist, mündet.

9. Gehäusedeckel nach einem der Ansprüche 1 bis 8, **dadurch gekennzeichnet, dass** ein eine Befestigungsmittel-Durchtrittsöffnung (110a, 110d, 110e) des Gehäusedeckels (100) im montierten Zustand des Gehäusedeckels (100) durchsetzendes Befestigungsmittel an einer die betreffende Befestigungsmittel-Durchtrittsöffnung (110a, 110d, 110e) umgebenden Vertiefung (142) anliegt.

10. Gehäusedeckel nach einem der Ansprüche 1 bis 9, **dadurch gekennzeichnet, dass** der Dichtungswulst (120) so ausgebildet und/oder angeordnet ist, dass ein Abschnitt des Dichtungswulstes (120) - in einer senkrecht zur Dichtungstragefläche (122) ausgerichteten Z-Richtung (128) gesehen - über seine gesamte Breite (b) oder über einen Teil seiner Breite (b) hinweg von einer eine Befestigungsmittel-Durchtrittsöffnung (110a, 110d, 110e) umgebenden Vertiefung (142) überlappt wird.

11. Gehäusedeckel nach einem der Ansprüche 1 bis 10, **dadurch gekennzeichnet, dass** der Dichtungswulst (120) zumindest abschnittsweise in einem Abstand (d) von dem Verformungsbegrenzungselement (126) verläuft, welcher kleiner ist als die Breite (b) des Dichtungswulstes (120) und/oder kleiner ist als die Breite (B) des Verformungsbegrenzungselements (126).

12. Gehäusedeckel nach einem der Ansprüche 1 bis 11, **dadurch gekennzeichnet, dass** die Breite (B) des Verformungsbegrenzungselements (126) kleiner ist als das Vierfache der Breite (b) des Dichtungswulstes (120).

13. Gehäusedeckel nach einem der Ansprüche 1 bis 12, **dadurch gekennzeichnet, dass** die Dichtungstragefläche (122) einen im Wesentlichen ebenen Bereich umfasst, welcher den Dichtungswulst (120) trägt und auf der dem Verformungsbegrenzungselement (126) abgewandten Seite eine Breite aufweist, welche größer ist als die Breite (b) des Dichtungswulstes (120).

14. Gehäusedeckel nach einem der Ansprüche 1 bis 13, **dadurch gekennzeichnet, dass** ein Grundkörper (152) des Gehäusedeckels (100), an welchem der Dichtungswulst (120) angeordnet ist, als ein Blechformteil ausgebildet ist.

15. Gehäusedeckel nach einem der Ansprüche 1 bis 14, **dadurch gekennzeichnet, dass** ein auf der dem Dichtungswulst (120) abgewandten Seite des Verformungsbegrenzungselements (126) verlaufender Randbereich (108) des Gehäusedeckels (100) eine Biegung aufweist.

## Claims

1. Housing cover for fixing to a housing (102), in particular to a power inverter housing,
wherein the housing cover (100) is provided with a plurality of fastening means through-openings (110) and with a sealing bead (120) that comprises an elastomeric material,
wherein the sealing bead (120) is arranged on a seal bearing surface (122) of the housing cover (100),
wherein the housing cover (100) comprises at least one deformation limiting element (126), which projects beyond the seal bearing surface (122) in the same direction (128) as the sealing bead (120) and limits a deformation of the sealing bead (120) in the assembled state of the housing cover (100), and
wherein at least one portion (138a, 138c, 138e, 138g, 138i, 138k) of at least one deformation limiting element (126) extends along the circumferential direction (140) of a fastening means through-opening (110) by a circumferential angle of at least 160° around the fastening means through-opening (110),
**characterized in that**
a recess (142) on the outside (144) of the housing cover (100) facing away from the seal bearing surface (122) is associated with the deformation limiting element (126).

2. Housing cover in accordance with Claim 1, **characterized in that** the deformation limiting element (126) is produced by reshaping a base body (152) of the housing cover (100).

3. Housing cover in accordance with either of Claims 1 or 2, **characterized in that** at least one portion (138e, 138g, 138i) of at least one deformation limiting element (126) extends in an annularly closed manner around a fastening means through-opening (110c, 110d, 110e).

4. Housing cover in accordance with any one of Claims 1 to 3, **characterized in that** at least one portion (138) of at least one deformation limiting element (126) is arranged on a side of a fastening means through-opening (110) that faces away from the sealing bead (120),
wherein preferably the at least one portion (138) of the at least one deformation limiting element (126) is arranged between the fastening means through-opening (110) and an outer rim (134) of the housing cover (100).

5. Housing cover in accordance with any one of Claims 1 to 4, **characterized in that** on the housing cover (100) a plurality of deformation limiting elements (126) are provided, which extend along a peripheral direction (136) of the housing cover (100) and are spaced at a distance from one another along the peripheral direction (136).

6. Housing cover in accordance with any one of Claims 1 to 5, **characterized in that** the sealing bead (120) is of annularly closed configuration, wherein preferably a region (124) of the seal bearing surface (122) that is surrounded by the sealing bead (120) is of substantially planar configuration.

7. Housing cover in accordance with any one of Claims 1 to 6, **characterized in that** the deformation limiting element (126) comprises a projection (130) extending in a longitudinal direction (154) of the deformation limiting element (126).

8. Housing cover in accordance with any one of Claims 1 to 7, **characterized in that** at least one fastening means through-opening (110a, 110d, 110e) of the housing cover (100) opens into a recess (142a, 142g, 142i) that is associated with a deformation limiting element (126).

9. Housing cover in accordance with any one of Claims 1 to 8, **characterized in that** a fastening means passing through a fastening means through-opening (110a, 110d, 110e) of the housing cover (100) in the assembled state of the housing cover (100) abuts on a recess (142) surrounding the respective fastening means through-opening (110a, 110d, 110e).

10. Housing cover in accordance with any one of Claims 1 to 9, **characterized in that** the sealing bead (120) is configured and/or arranged such that a portion of the sealing bead (120), seen in a Z-direction (128) oriented perpendicularly to the seal bearing surface (122), is overlapped across its entire width (b) or across part of its width (b) by a recess (142) surrounding a fastening means through-opening (110a, 110d, 110e).

11. Housing cover in accordance with any one of Claims 1 to 10, **characterized in that** the sealing bead (120) runs at least in sections at a distance (d) from the deformation limiting element (126), which distance is smaller than the width (b) of the sealing bead (120) and/or is smaller than the width (B) of the deformation limiting element (126).

12. Housing cover in accordance with any one of Claims 1 to 11, **characterized in that** the width (B) of the deformation limiting element (126) is smaller than four times the width (b) of the sealing bead (120).

13. Housing cover in accordance with any one of Claims 1 to 12, **characterized in that** the seal bearing surface (122) comprises a substantially planar region, which bears the sealing bead (120) and on the side facing away from the deformation limiting element (126) has a width, which is greater than the width (b) of the sealing bead (120).

14. Housing cover in accordance with any one of Claims 1 to 13, **characterized in that** a base body (152) of the housing cover (100) on which the sealing bead (120) is arranged is configured as a shaped sheet metal part.

15. Housing cover in accordance with any one of Claims 1 to 14, **characterized in that** a rim region (108) of the housing cover (100) running on the side of the deformation limiting element (126) facing away from the sealing bead (120) has a bend.

## Revendications

1. Couvercle de boîtier destiné à être fixé sur un boîtier (102), en particulier sur un boîtier d'onduleur,
dans lequel le couvercle de boîtier (100) est pourvu de plusieurs ouvertures de passage de moyen de fixation (110) et d'un bourrelet d'étanchéité (120), qui comprend un matériau élastomère,
dans lequel le bourrelet d'étanchéité (120) est disposé sur une surface de support d'étanchéité (122) du couvercle de boîtier (100),
dans lequel le couvercle de boîtier (100) comprend au moins un élément de limitation de déformation (126), qui fait saillie au-delà de la surface de support d'étanchéité (122) dans la même direction (128) que le bourrelet d'étanchéité (120) et limite une déformation du bourrelet d'étanchéité (120) dans l'état monté du couvercle de boîtier (100), et
dans lequel au moins une section (138a, 138c, 138e, 138g, 138i, 138k) d'au moins un élément de limitation de déformation (126) s'étend le long de la direction circonférentielle (140) d'une ouverture de passage de moyen de fixation (110) d'un angle circonférentiel d'au moins 160° autour de l'ouverture de passage de moyen de fixation (110),
**caractérisé en ce**
**qu'**un creux (142) sur le côté extérieur (144) du couvercle de boîtier (100) opposé à la surface de support d'étanchéité (122) est associé à l'élément de limitation de déformation (126).

2. Couvercle de boîtier selon la revendication 1, **caractérisé en ce que** l'élément de limitation de déformation (126) est généré par la mise en forme d'un corps de base (152) du couvercle de boîtier (100).

3. Couvercle de boîtier selon l'une quelconque des revendications 1 ou 2, **caractérisé en ce qu'**au moins une section (138e, 138g, 138i) d'au moins un élément de limitation de déformation (126) s'étend de manière fermée en forme d'anneau autour d'une ouverture de passage de moyen de fixation (110c, 110d, 110e).

4. Couvercle de boîtier selon l'une quelconque des revendications 1 à 3, **caractérisé en ce qu'**au moins une section (138) d'au moins un élément de limitation de déformation (126) est disposée sur un côté opposé au bourrelet d'étanchéité (120) d'une ouverture de passage de moyen de fixation (110),
dans lequel, de préférence, l'au moins une section (138) de l'au moins un élément de limitation de déformation (126) est disposée entre l'ouverture de passage de moyen de fixation (110) et un bord extérieur (134) du couvercle de boîtier (100).

5. Couvercle de boîtier selon l'une quelconque des revendications 1 à 4, **caractérisé en ce que** sont prévus sur le couvercle de boîtier (100) plusieurs éléments de limitation de déformation (126), qui s'étendent le long d'une direction circonférentielle (136) du couvercle de boîtier (100) et sont espacés les uns des autres le long de la direction circonférentielle (136).

6. Couvercle de boîtier selon l'une quelconque des revendications 1 à 5, **caractérisé en ce que** le bourrelet d'étanchéité (120) est réalisé de manière fermée en forme d'anneau,
dans lequel une zone (124) de la surface de support d'étanchéité (122) entourée par le bourrelet d'étanchéité (120) est réalisée de préférence de manière sensiblement plane.

7. Couvercle de boîtier selon l'une quelconque des revendications 1 à 6, **caractérisé en ce que** l'élément de limitation de déformation (126) comprend une saillie (130) s'étendant dans une direction longitudinale (154) de l'élément de limitation de déformation (126).

8. Couvercle de boîtier selon l'une quelconque des revendications 1 à 7, **caractérisé en ce qu'**au moins une ouverture de passage de moyen de fixation (110a, 110d, 110e) du couvercle de boîtier (100) débouche dans un creux (142a, 142g, 142i), qui est associé à un élément de limitation de déformation (126).

9. Couvercle de boîtier selon l'une quelconque des revendications 1 à 8, **caractérisé en ce qu'**un moyen de fixation traversant une ouverture de passage de moyen de fixation (110a, 110d, 110e) du couvercle de boîtier (100) dans l'état monté du couvercle de boîtier (100) repose sur un creux (142) entourant l'ouverture de passage de moyen de fixation (110a, 110d, 110e) concernée.

10. Couvercle de boîtier selon l'une quelconque des revendications 1 à 9, **caractérisé en ce que** le bourrelet d'étanchéité (120) est réalisé et/ou est disposé de telle sorte qu'une section du bourrelet d'étanchéité (120) - vue dans une direction Z (128) orientée perpendiculairement à la surface de support d'étanchéité (122) - est chevauchée - sur toute sa largeur (b) ou sur une partie de sa largeur (b) - d'un creux (142) entourant une ouverture de passage de moyen de fixation (110a, 110d, 110e).

11. Couvercle de boîtier selon l'une quelconque des revendications 1 à 10, **caractérisé en ce que** le bourrelet d'étanchéité (120) s'étend au moins par endroits à une distance (d) de l'élément de limitation de déformation (126) qui est inférieure à la largeur (b) du bourrelet d'étanchéité (120) et/ou est inférieure à la largeur (B) de l'élément de limitation de déformation (126).

12. Couvercle de boîtier selon l'une quelconque des revendications 1 à 11, **caractérisé en ce que** la largeur (B) de l'élément de limitation de déformation (126) est inférieure à quatre fois la largeur (b) du bourrelet d'étanchéité (120).

13. Couvercle de boîtier selon l'une quelconque des revendications 1 à 12, **caractérisé en ce que** la surface de support d'étanchéité (122) comprend une zone sensiblement plane qui supporte le bourrelet d'étanchéité (120) et présente sur le côté opposé à l'élément de limitation de déformation (126) une largeur qui est supérieure à la largeur (b) du bourrelet d'étanchéité (120).

14. Couvercle de boîtier selon l'une quelconque des revendications 1 à 13, **caractérisé en ce qu'**un corps de base (152) du couvercle de boîtier (100), sur lequel le bourrelet d'étanchéité (120) est disposé, est réalisé en tant que pièce moulée en tôle.

15. Couvercle de boîtier selon l'une quelconque des revendications 1 à 14, **caractérisé en ce qu'**une zone de bord (108) du couvercle de boîtier (100) s'étendant sur le côté de l'élément de limitation de déformation (126) opposé au bourrelet d'étanchéité (120) présente une flexion.
